# EUROPEAN PATENT SPECIFICATION

(11) **EP 0 111 402 B1**
(45) Date of publication and mention of the grant of the patent: **18.08.1993**
(21) Application number: 83307191.3
(22) Date of filing: 24.11.1983
(51) Int. Cl.: H01L 27/14, H01L 31/02, H01L 31/18

(54) **Photoelectric conversion device**
Fotovoltaischer Wandler
Dispositif de conversion photovoltaique

(30) Priority: 24.11.1982 JP 206806/82; 24.11.1982 JP 206809/82; 22.02.1983 JP 28211/83; 29.04.1983 JP 75713/83; 31.10.1983 JP 204443/83
(43) Date of publication of application: 20.06.1984
(73) Proprietor: SEMICONDUCTOR ENERGY LABORATORY CO., LTD., Setagaya-ku Tokyo 157 (JP)
(72) Inventor: Yamazaki, Shunpei c/o Semiconductor Energy, Setagaya-ku Tokyo (JP)
(74) Representative: Milhench, Howard Leslie

(56) References cited:
- WO-A-83/00409
- GB-A- 558 300
- GB-A- 2 023 929
- GB-A- 2 080 621
- GB-A- 2 095 908
- US-A- 4 262 411
- US-A- 4 281 208
- US-A- 4 292 092
- EXTENDED ABSTRACTS, vol. 79-2, 14th-19th October 1979, pages 1498-99, no. 598, Princeton, New Jersey, US; S.VARMA et al.: "Formation of ultrathin semiconducting layers of SnO2 on Si

## Description

### BACKGROUND OF THE INVENTION

### Field of the Invention

The present invention relates to improvements in or relating to a photoelectric conversion device in which a number of semiconductor elements are sequentially arranged on a substrate in side-by-side relation and connected in series.

The invention also pertains to a method for the manufacture of such a photoelectric conversion device.

### Description of the Prior Art

There has been proposed in GB-A-2080621 and US-A-4315096 a photoelectric conversion device comprising a plurality of series-connected photoelectric elements Uᵢ(i=1,2,...n) each of which comprises a semiconductor layer Qᵢ having formed therein at least one semiconductor junction and first and second electrodes Eᵢ, Fᵢ which sandwich said semiconductor layer Qᵢ therebetween so that said first electrode Eᵢ makes contact with the surface of a first conductivity type portion of the semiconductor layer Qᵢ and said second electrode Fᵢ makes contact with the surface of a second conductivity type portion of the semiconductor layer Qᵢ, said second conductivity type being of opposite conductivity to said first conductivity type, and said photoelectric elements Uᵢ being series-connected with one another by virtue of one electrode of each element having a portion connected to the other electrode of another element.

More particularly, the abovementioned device of GB-A-2080621 and US-A-4315096 comprises a substrate having an insulating surface; and a plurality of semiconductor elements U₁ to Uₙ (n being an integer larger than one) formed thereon in side by side relationship and connected sequentially in series one with another; the semiconductor element Uᵢ (i=1, 2,...n) comprising a first electrode Eᵢ formed on the substrate, a non-single-crystal semiconductor laminate member Qᵢ formed on the first electrode Eᵢ and having formed therein at least one semiconductor junction, and a second electrode Fᵢ formed on the non-single-crystal-semiconductor laminate member Qᵢ in opposing relationship to the first electrode Eᵢ; the second electrode Fⱼ₊₁ (j=1,2,...(n-1)) of the semiconductor element Uⱼ₊₁ being coupled with the first electrode Eⱼ of the semiconductor element Uⱼ through a coupling portion Kⱼ formed as an extension of the second electrode Fⱼ₊₁.

With such a semiconductor photoelectric conversion device as is described in GB-A-2080621 and US-A-4315096 abovementioned, electrical loss resulting from the contact resistance between the coupling portion Kⱼ and the first electrode Eⱼ is an obstacle to enhancement of the photoelectric conversion efficiency. For reducing the electrical loss and thereby raising the photoelectric conversion efficiency, it is necessary that the contact resistance between the coupling portion Kⱼ and the electrode Eⱼ should be low and should not increase in long-term use of the device.

In the abovesaid conventional photoelectric conversion device, however, no consideration is paid to so designing the coupling portion Kⱼ and the electrode Eⱼ as to prevent the contact resistance therebetween from increasing in long-term use. Accordingly, this prior art device possesses the defect that its photoelectric conversion efficiency will decrease with long-term use.

Further, in the photoelectric conversion device mentioned above, the coupling portion Kⱼ is shown to be coupled to the upper surface of the first electrode Eⱼ. With this arrangement, in order to obtain good contact between the coupling portion Kⱼ and the first electrode Eⱼ it is necessary that the area of the contact portion in the lateral direction be increased, but this makes it impossible to form the photoelectric conversion device with high density. When the coupling portion Kⱼ makes contact with the first electrode Eⱼ only at the upper surface thereof, a high density device is obtainable only if the contact area between the coupling portion Kⱼ and the first electrode Eⱼ is extremely small, and with such a small contact area a sufficiently good contact cannot be obtained.

For the abovementioned reasons, the aforementioned prior art photoelectric conversion device cannot achieve low electrical loss with high density.

### SUMMARY OF THE INVENTION

It is therefore an object of the present invention to provide an improved photoelectric conversion device which is free from the aforesaid defects.

In accordance with one aspect of the present invention there is provided a photoelectric conversion device comprising an insulating substrate and a plurality of adjacent series-connected photoelectric elements Uᵢ(i=1,2,...n) each of which comprises a silicon based non-single crystal semiconductor layer Qᵢ having formed therein at least one semiconductor junction and first and second electrodes Eᵢ, Fᵢ which sandwich said semiconductor layer Qᵢ therebetween so that said first electrode Eᵢ makes contact with the surface of a first conductivity type portion of the semiconductor layer Qᵢ and said second electrode Fᵢ makes contact with the surface of a second conductivity type portion of the semiconductor layer Qᵢ, said second conductivity type being of opposite conductivity to said first conductivity type, and said photoelectric elements Uᵢ being series-connected with one another by virtue of one electrode Fⱼ₊₁ (j=1,2...(n-1)) of each element Uⱼ₊₁ having an integrally formed coupling portion Kⱼ in contact with the other electrode Eⱼ of another element Uⱼ, as is known from GB-A-2080621 and US-A-4315096 abovementioned, which is characterized in accordance with the invention in that said first and second electrodes Eᵢ, Fᵢ comprise electrically-conductive metal oxide layers contacting the respective surfaces of the semiconductor layer Qᵢ, and the metal oxide layer contacting the P-type surface of the semiconductor layer is tin oxide or a metal oxide consisting principally of tin oxide, and the metal oxide layer contacting the N-type surface of the semiconductor layer is indium oxide or a metal oxide consisting principally of indium oxide.

More particularly, the present invention provides a photoelectric conversion device wherein the semiconductor element Uᵢ (i=1, 2,...n) comprises a non-single-crystal semiconductor laminate member Qᵢ formed on the first electrode Eᵢ and having formed therein at least one semiconductor junction, and the second electrode Fᵢ is formed on the non-single-crystal-semiconductor laminate member Qᵢ in opposing relationship to the first electrode Eᵢ; the coupling portion Kⱼ is formed as an extension of the second electrode Fⱼ₊₁; the second electrode Fᵢ and the coupling portion Kⱼ comprise an electrically conductive metal oxide substantially different to the electrically conductive metal oxide of the first electrode Eⱼ.

Since the first and second electrode layers Eᵢ and Fᵢ contacting the non-single-crystal semiconductor laminate member Qᵢ are both formed of metal oxide, therefore, even if the device were to be used for a long time, no such reaction as might lead to an increase in the contact resistance between the electrodes would in practice occur. Consequently, the contact resistance between the coupling portion Kⱼ and the first electrode Eⱼ will not increase during long-term use of the device and correspondingly electrical loss in the device will not be increased by long-term use. Additionally, by forming the metal oxide electrodes of different metal oxides selected to provide compatibility with the different conductivity type regions of the semiconductor a device having increased long-term reliability is obtained. By virtue of the invention, therefore, a photoelectric conversion device is provided which maintains its high photoelectric conversion efficiency for a long period of time.

In accordance with a subordinate feature of the present invention, a groove 0ⱼ is formed in the non-single-crystal semiconductor laminate member Qⱼ so as to extend between the second electrode Fⱼ₊₁ and the first electrode Eⱼ, and the coupling portion Kⱼ extends into the groove 0ⱼ to make contact with the first electrode Eⱼ where it is exposed by the groove 0ⱼ. The groove 0ⱼ can extend into the thickness of the first electrode Eⱼ and can even extend through the first electrode Eⱼ and into the substrate and by this means the contact area between the first electrode Eⱼ and the second electrode Fⱼ₊₁ can be increased without any increase in the lateral direction whereby a high density photoelectric conversion device which exhibits low electrical loss and hence is high in photoelectric conversion efficiency can be obtained.

As will be described hereinafter, the photoelectric conversion device of the present invention can be formed by a process including the following steps (a) to (d):
(a) a first conductive metal oxide layer which will ultimately serve as a first electrode of each photoelectric element, is formed on an insulating substrate and is subjected to first scanning by a laser beam, thereby providing the first electrode of each photoelectric element;
(b) a non-single-crystal silicon based semiconductor laminate member, which will ultimately serve as the non-single-crystal semiconductor laminate member of each photoelectric element and has formed therein at least one semiconductor junction, is formed on the substrate in such a manner as to cover the first electrode of each photoelectric element;
(c) the non-single-crystal semiconductor laminate member is subjected to second scanning by a laser beam thereby cutting therein grooves which expose the first electrodes and divide the semiconductor into a plurality of discrete elements, one for each photoelectric element;
(d) a second conductive metal oxide layer which will ultimately serve as a second electrode of each photoelectric element, is formed over the divided non-single-crystal semiconductor laminate members and into the grooves, and then the second conductive layer is subjected to third scanning by a laser beam, thereby providing the second electrode of each photoelectric element.

According to the manufacturing method including the abovesaid steps, and by virtue of forming the electrodes of the plural photoelectric elements of specific metal oxides which will not deteriorate with long-term use and moreover of using different metal oxides to contact different conductivity type regions of the semiconductor layer for enhanced compatibility therewith, the coupling portion of the second electrode of each photoelectric element, formed by an extension of the second electrode itself, will be connected with the first electrode of the immediately preceding photoelectric element through an excellent electrical coupling providing stable long-term characteristics and leading to a photoelectric conversion device of high photoelectric conversion efficiency.

Therefore, in accordance with another aspect of the present invention there is provided a method of manufacturing a photoelectric conversion device comprising forming a plurality of spaced apart first electrodes (Eᵢ) on an insulating substrate, forming a silicon based non-single crystal semiconductor layer having a first conductivity type portion overlying all of the spaced-apart first electrodes (Eᵢ), said semiconductor layer having formed therein at least one semiconductor junction and having a second, opposite conductivity type portion remote from said first conductivity type portion, dividing said semiconductor layer so as to define a plurality of separate semiconductor layers (Qᵢ) each associated with a respective one of said plurality of first electrodes (Eᵢ) and so as to expose a portion of each of the respective first electrodes, forming a second electrode layer overlying the second conductivity type portions of all of the separate semiconductor layers (Qᵢ) and contacting the exposed portions of the first electrodes (Eᵢ), and dividing the second electrode layer so as to define a plurality of separate second electrodes (Fᵢ) each associated with a respective first electrode (Eᵢ) and a respective one of the separate semiconductor layers (Qᵢ) so as to constitute therewith a photoelectric element (Uᵢ), each photoelectric element being series connected to adjacent like photoelectric elements by providing one electrode (Fⱼ₊₁) of each element (Uⱼ₊₁) with an integrally formed coupling portion Kⱼ in contact with the other electrode Eⱼ of another element, as known from GB-A-2080621 aforementioned, and which is characterized in accordance with the present invention in that the first and second electrode layers are formed as electrically-conductive metal oxide layers, and the metal oxide layer contacting the P-type surface of the semiconductor layer is tin oxide or a metal oxide consisting principally of tin oxide, and the metal oxide layer contacting the N-type surface of the semiconductor layer is indium oxide or a metal oxide consisting principally of indium oxide.

During the prosecution of this application, the Applicants attention has been drawn by the European Patent Office to W0-A-8300409 which was published on 3 February 1983, namely after the earliest claimed priority date (24 November 1982) of the present application, but does itself claim the earlier priority date of 16 July 1981. The disclosure of W0-A-8300409 if entitled to its claimed priority date is thus to be considered as comprised in the state of the art in accordance with Article 54(3) EPC in respect of the subject matter of the first and second Japanese patent applications from which the present application claims priority, and as comprised in the state of the art in accordance with Article 54(2) EPC in respect of the subject matter of the remaining three Japanese applications from which the present application claims priority. Disclosed in W0-A-8300409 are solar cells and arrays of solar cells made as thin films on insulating substrates. In a first embodiment configured as an individual photoelectric conversion device, by use of masking techniques a thin conductive film is deposited on a glass substrate, a semiconductor film incorporating a P-N junction is deposited on top of the conductive film, a second conductive film is deposited on top of the semiconductor film, and contacts are made to edges of the conductive films. In a second embodiment, an array of such cells is made by shifting the mask between successive deposition steps so that an edge of the second conductive film of one cell overlaps an edge of the first conductive film of an adjacent cell for connecting the cells in series. Mention is made in W0-A-8300409 of forming one or other of the conductive films as discrete films of ITO (indium-tin oxide) and gold, but there is no disclosure in W0-A-8300409 of a photoelectric conversion device or a method of making the same in accordance with the present invention and as claimed in the appended claims.

A further photoelectric conversion device is disclosed in GB-A-2095908.

Other features of the present invention are set forth in the appended claims and will become more fully apparent from consideration of the following detailed description taken in conjunction with the accompanying drawings.

### BRIEF DESCRIPTION OF THE DRAWINGS

Fig.1 is a plan view schematically illustrating an embodiment of the present invention;
Fig.2 is a schematic sectional view taken on the line II-II in Fig.1;
Figs.3A to D are detailed cross-sectional views showing on an enlarged scale parts of the embodiment of the present invention shown in Fig.2;
Figs. 4A and B are detailed sectional views showing on an enlarged scale other parts of the embodiment of Fig.1;
Figs. 5A to G are cross-sectional views schematically showing some of the sequential steps involved in the manufacture of the photoelectric conversion device of the embodiment of the present invention depicted in Figs. 1 to 4;
Figs. 6A to D, 7A to D and 8 are schematic cross-sectional views, similar to Fig. 3, illustrating other embodiments of the present invention, respectively;
Fig. 9 is a plan view schematically illustrating another embodiment of the present invention;
Fig. 10 is a schematic cross-sectional view taken on the line X-X in Fig. 9;
Fig. 11 is an enlarged cross-sectional view showing a part of the photoelectric conversion device of the present invention illustrated in Figs. 9 and 10; and
Fig. 12 is a schematic cross-sectional view showing some of the sequential steps involved in the manufacture of the photoelectric conversion device depicted in Fig. 9 and 10.

### DESCRIPTION OF THE PREFERRED EMBODIMENTS

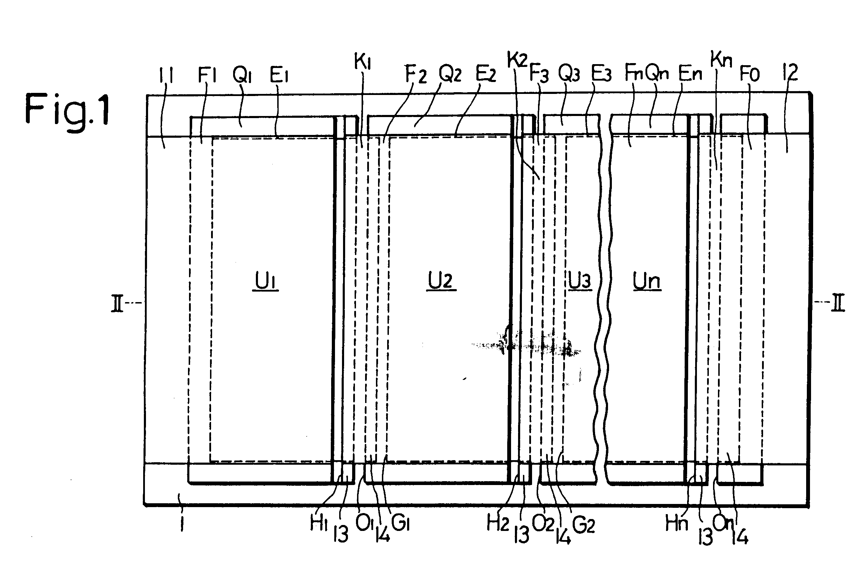

A description will be given first, with reference to Figs. 1 to 3, of an embodiment of the present invention.

The embodiment of the photoelectric conversion device of the present invention shown in Figs. 1 to 3 has a plurality n (n being an integer larger than one) of photo semiconductor elements U₁ to Uₙ formed side by side on a substrate 1.

The substrate 1 has an insulating surface 2.

The substrate 1 may be a light-transparent substrate made of glass, organic synthetic resin or the like, or a flexible sheet as of organic synthetic resin. It is also possible to employ a non-light-transparent substrate of ceramics, organic resin or the like, a non-light-transparent metal substrate having its surface insulated, or a flexible, insulating sheet-like member having an insulating film formed on the surface of a flexible metallic sheet. The substrate 1 is, for example, rectangular in shape and 20 cm wide and 60 cm long.

In the case of the substrate 1 being the abovesaid flexible metallic sheet-like member, it is made, for instance, of aluminum or an aluminum-base alloy and has a thickness of, for example, 10 to 200 µm, preferably, 50 to 150 µm.

The insulating film formed on the surface of the flexible metallic sheet-like member is, for example, an oxide film resulting from oxidation of the surface of the sheet-like member. When the flexible metallic sheet-like member is made of aluminum or an aluminum-base alloy, the abovesaid oxide film is an aluminum oxide (alumina Al₂O₃) or an insulating material consisting principally of the aluminum oxide. The oxide film has a thickness small enough not to impair the flexibility of the flexible metallic sheet-like member, for instance, in the range of 0.1 to 2 µm, preferably, 0.3 to 1 µm. Such an oxide film can be formed by calorizing the flexible metallic sheet-like member made of aluminum or the aluminum-base alloy.

The photo semiconductor element Uᵢ (i=1, 2, ....n) on the substrate 1 has an electrode Eᵢ formed on the substrate 1, a non-single-crystal semiconductor laminate member Qᵢ formed on the electrode Eᵢ and an electrode Fᵢ formed on the non-single-crystal semiconductor laminate member Qᵢ in opposing relation to the electrode Eᵢ.

The electrode Eᵢ is, for example, rectangular in shape and has a width of 5 to 40 mm, preferably 15 mm and a length slightly smaller than the length of the substrate 1.

Electrodes Eⱼ(j=1, 2, ...(n-1)) and Eⱼ₊₁ are spaced apart by a groove Gⱼ which is shown to extend in the vertical direction in Fig. 1. The groove Gⱼ is, for example, 40 µm wide.

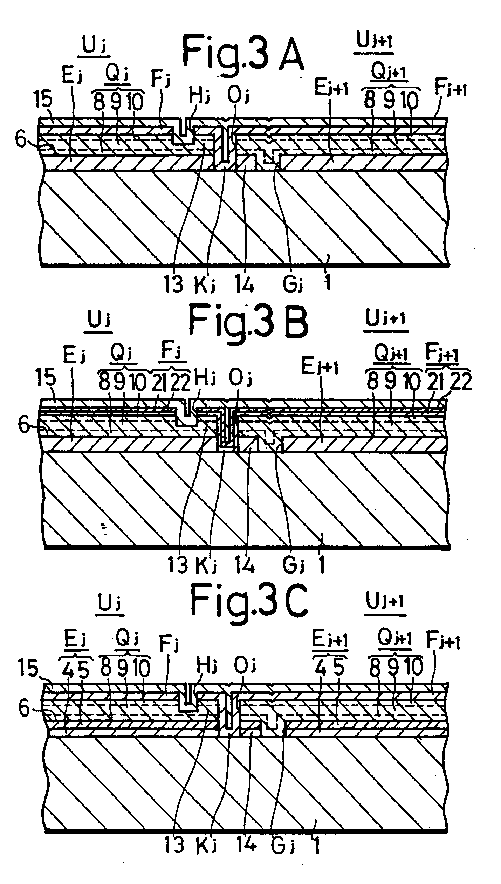

The electrode Eᵢ may be a single-layer structure as shown in Fig. 3A.

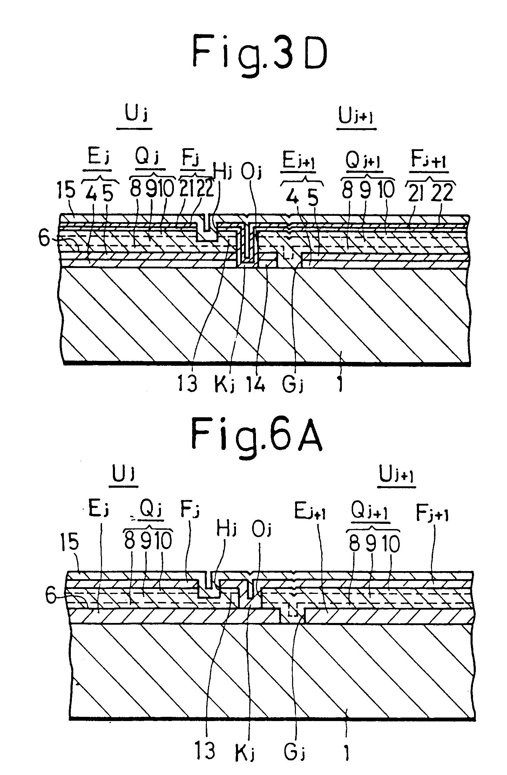

The electrode Eᵢ may also be a two-layer structure which comprises a layer 4 making contact with the substrate 1 and a layer 5 formed on the layer 4 in contact with the non-single-crystal semiconductor laminate member Qᵢ as shown in Figs. 3C and D. Also it is possible to employ a three-layer structure having another layer sandwiched between the layers 4 and 5 though not shown.

The electrode Eᵢ may be a reflective electrode when the electrode Fᵢ is light-transparent. When the electrode Eᵢ is the reflective electrode, light incident on the non-single-crystal semiconductor laminate member Qᵢ on the opposite side from the substrate 1 passes through the non-single-crystal semiconductor laminate member Qᵢ, then is reflected by the surface of the electrode Eᵢ back to the non-single-crystal semiconductor laminate member Qᵢ to pass therethrough. The larger the optical path length of the reflected light in the non-single-crystal semiconductor laminate member Qᵢ is, the more the utilization efficiency of light is raised. From this point of view, it is preferable that the surface of the electrode Eᵢ on the side of the non-single-crystal semiconductor laminate member Qᵢ have irregularities oblique to planes perpendicular to the substrate surface to form a diffuse reflection surface 6 at the boundary between it and the non-single-crystal semiconductor laminate member Qᵢ.

In the case where the electrode Eᵢ is a reflective electrode and has the two-layer structure comprised of the layers 4 and 5, in order to simultaneously satisfy the requirements that the electrode Eᵢ be of high conductivity and high reflectivity and to prevent that when the non-single-crystal semiconductor laminate member Qᵢ is formed, the material of its non-single-crystal semiconductor layer on the side of the electrode Eᵢ or an impurity contained therein reacts with the material of the reflective electrode to form a layer of high contact resistance in the interface between the electrode Eᵢ and the non-single-crystal semiconductor layer Qᵢ, it is preferable that the layer 4 be a reflective conductive layer and the layer 5 a light trans-parent metal oxide layer 5.

In the case where the layer 4 of the electrode Eᵢ is the reflective conductive layer, it may preferably be made of metal. The metal may be stainless steel but, in view of the requirements of high conductivity and high reflectivity for the electrode Eᵢ, it is preferable to employ aluminum (Al), silver (Ag), an aluminum-base alloy containing, for example, 0.1 to 2 volume% of silicon, or a silver-base alloy.

When the layer 5 of the electrode Eᵢ is a light-transparent metal oxide layer, in order to ensure that the layer 5 be high in conductivity and in transmittance and to prevent that when the non-single-crystal semiconductor laminate layer Qᵢ is formed, the metallic oxide reacts with the material or impurity of the non-single-crystal semiconductor layer of the laminate member Qᵢ on the side of the electrode Eᵢ to form the abovesaid high contact resistance layer, the layer 5 is formed of a tin oxide (Sn0₂ or Sn0) or a metallic oxide consisting principally of such a tin oxide, for instance, a tin oxide containing halogen or, 1 to 10 wt% of antimony oxide in the event that the non-single-crystal semiconductor layer of the non-single-crystal semiconductor laminate member Qᵢ on the side of the electrode Eᵢ is p-type. In the case where the layer of the non-single-crystal semiconductor laminate member Qᵢ on the side of the electrode Eᵢ is N-type, an indium oxide or a metallic oxide consisting principally thereof, for instance an indium oxide containing l to l0 wt% of tin oxide, is used. In this case, the light transparent conductive layer 5 is 300 to 600 A thick.

In the case where the electrode Eᵢ is such a two-layer reflective electrode comprising the layer 4 and the layer 5, when the abovesaid diffuse reflection surface 6 is formed at the boundary between the electrode Eᵢ and the non-single-crystal semiconductor laminate member Qᵢ, it is formed on the surface of the layer 5 on the side of the laminate member Qᵢ.

In the case where the electrode Eᵢ is comprised of the layers 4 and 5 these layers are a reflective conductive layer and a light-transparent conductive layer to form a reflective electrode, the surface of the layer 4 may also be formed as the diffuse reflection surface in the interface between it and the light-transparent conductive layer 5, through not shown.

When the substrate 1 is light-transparent, the electrode Eᵢ is formed as a light-transparent electrode.

In such a case, the light-transparent electrode may be a single metal oxide layer.

Where the electrode Eᵢ is a single-layer light-transparent electrode, when the non-single-crystal semiconductor layer of the non-single-crystal laminate member Qᵢ on the side of the electrode Eᵢ is P-type, the electrode Eᵢ is formed of a tin oxide or a metal oxide consisting principally thereof for the same reasons as given previously.

When the abovesaid non-single-crystal semiconductor layer is N-type, the electrode Eᵢ is a metal oxide layer formed of indium oxide or a metal oxide consisting principally thereof.

In the case where the electrode Eᵢ has the two-layer structure comprised of the layers 4 and 5 and is light-transparent, if the non-single-crystal semiconductor layer of the non-single-crystal semiconductor laminate member Qᵢ on the side of the electrode Eᵢ is P-type, it is preferable that the layer 5 be a metal oxide layer formed of a tin oxide or consisting principally thereof and the layer 4 a metal oxide layer formed of an indium oxide or consisting principally thereof.

When the electrode Fᵢ is light-transparent, the electrode Eᵢ need not always be reflective.

In the semiconductor element Uᵢ formed on the substrate 1, the non-single-crystal semiconductor laminate member Qⱼ₊₁ (j=1, 2,...(n-1)) on the aforesaid electrode Eⱼ₊₁ extends laterally from the marginal edge of the electrode Eⱼ₊₁ on the opposite side from the electrode Eⱼ to a position on the electrode Eⱼ on the side of the electrode Eⱼ₊₁ across the groove Gⱼ separating the electrode Eⱼ and Eⱼ₊₁ making contact with the non-single-crystal semiconductor laminate member Qⱼ.

The non-single-crystal semiconductor laminate member Q₁ formed on the electrode E₁ extends laterally onto the substrate 1 to cover the side surface of the electrode E₁ on the opposite side from the electrode E₂.

Further, laminate member Qₙ is formed as a non-single-crystal-semiconductor laminate member Q₀ to laterally extend onto the substrate 1 to cover the side surface of the electrode Eₙ on the opposite side from the electrode Eₙ₋₁.

The non-single-crystal semiconductor laminate member Qᵢ is formed to vertically extend to cover the electrode Eᵢ. The non-single-crystal semiconductor laminate member Qᵢ has cut therein a groove Oᵢ which is shown to extend in the vertical direction in Fig. 1. The grooves O₁ to Oₙ are formed simultaneously.

The non-single-crystal semiconductor laminate member Qᵢ formed on the electrode Eᵢ may be formed by one or more two-layer structures each composed of a P-type or N-type non-single-crystal semiconductor layer and another non-single-crystal semiconductor layer of the opposite conductivity type.

Accordingly, the non-single-crystal semiconductor laminate member Qᵢ can be formed to have at least one PN junction.

Furthermore, the non-single-crystal semiconductor laminate member Qᵢ may preferably be formed by one or more three-layer structures, each composed of a P-type or N-type non-single-crystal semiconductor layer 8, an I-type non-single-crystal semiconductor layer 9 and a non-single-crystal semiconductor layer 10 opposite in conductivity type to the layer 8 as shown in Fig. 3. Accordingly, the non-single-crystal semiconductor laminate member Qᵢ may preferably be formed to have at least one PIN junction. As regards the energy gaps of the layers 8, 9 and 10 there are various possibilities. If the substrate and the first electrode Eᵢ are light transparent then the layer 8 can for example have a wider energy gap than do the layers 9 and 10, or the layers 8 and 10 can have a wider energy gap than does the layer 9. If the second electrode Fᵢ is light transparent, then the layer 10 can for example have a wider energy gap than do the layers 8 and 9, or the layers 8 and 10 can have a wider energy gap than does the layer 9.

The non-single-crystal semiconductor layer of the non-single-crystal semiconductor laminate member Qᵢ on the side of the electrode Eᵢ is P-type when the layer of the electrode Eᵢ making contact with the non-single-crystal semiconductor laminate member Qᵢ is formed by a tin oxide or metallic oxide consisting principally of the tin oxide as described previously in respect of Fig. 3. When the layer 5 of the electrode Eᵢ making contact with the non-single-crystal semiconductor laminate member Qᵢ is formed by an indium oxide or metallic oxide consisting principally of the indium oxide, the non-single-crystal semiconductor layer of the non-single-crystal semiconductor laminate member Qᵢ on the side of the electrode Eᵢ is N-type.

Accordingly, in the case where the non-single-crystal semiconductor laminate member Qᵢ has the three-layer structure comprising the non-single-crystal semiconductor layers 8, 9 and 10 as illustrated in Fig. 3 and the layer of the electrode Eᵢ semiconductor laminate member Qᵢ is formed by the tin oxide or metallic oxide consisting principally of the tin oxide, the non-single-crystal semiconductor layers 8 and 10 are P-type and N-type, respectively. When the light transparent conductive layer 5 is formed by the indium oxide or metal oxide consisting principally of indium oxide, the non-single-crystal semiconductor layers 8 and 10 are N-type and P-type, respectively.

The non-single-crystal semiconductor layers making up the non-single-crystal semiconductor laminate member Qᵢ are formed of silicon or a semiconductor consisting principally of silicon.

When the non-single-crystal semiconductor laminate member Qᵢ has the three-layer structure composed of the non-single-crystal semicodnuctor layers 8, 9 and 10, the non-single-crystal semicodncutor layer 8 may be formed, for instance, of silicon to a thickness of 5 to 300 A, preferably 70 to 130 A. Where the non-single-crystal semiconductor layer 8 is P-type, for example, boron (B) may be introduced thereinto as a P-type impurity.

The non-single-crystal semiconductor layer 9 can be formed of silicon as is the case with the non-single-crystal semiconductor layer 8 but its thickness may preferably be larger than that of the layer 8, for instance, 0.4 to 0.7µm. The non-single-crystal semiconductor layer 9 contains a very small amount of a P-type impurity or does not substantially contain either of P-type or N-type impurities and, if any, their concentrations are negligibly low.

The non-single-crystal semiconductor layer 10 can also be formed of silicon as is the case with the non-single-crystal semiconductor layer 8. But since the non-single-crystal semiconductor layer 10 is disposed on the side where the light to be converted is incident on the semiconductor element, it may preferably be formed of a semiconductor which has a larger energy band gap than does the semiconductor material of the non-single-crystal semiconductor layer 8, such as, for example, silicon carbide expressed by SiₓC₁₋ₓ (0<x<1). In this case, the non-single-crystal semiconductor layer 10 can be formed to a thickness of 5 to 300 Å, (10 Å ≡ 1nm) typically, in the range of 7 to 130 Å. Other materials which could be used for the layer 10 might for example be SiₓGe₁₋ₓ (0<x<1) or Si₃N₄₋ₓ (0<x<4).

Incidentally, the aforesaid non-single-crystal semiconductor laminate member Qₒ has the same structure as the aforementioned one Qᵢ.

In the semiconductor element Uᵢ formed on the substrate 1, the electrode Fᵢ on the non-single-crystal semiconductor laminate member Qᵢ is disposed opposite to the electrode Eᵢ formed on the non-single-crystal semiconductor laminate member Qᵢ.

In this case, the electrode Fⱼ₊₁ extends from a position apart from the isolated end portion of the non-single-crystal semiconductor laminate member Qⱼ₊₁ on the opposite side from the non-single-crystal semiconductor laminate member Qⱼ onto its isolated end portion on the side of the non-single-crystal semiconductor laminate member Qⱼ₊₁.

The electrode Fᵢ extends from a position away from the isolated end portion of the non-single-crystal laminate member Q₁ on the side of the non-single-crystal semiconductor laminate member Q₂ to the marginal edge of the substrate 1 to cover the extension of the non-single-crystal laminate member Q₁ on the side surface of the electrode E₁.

On the non-single-crystal semiconductor laminate member Qₙ, an electrode F₀ Similar to the electrode Fₙ is formed to extend from the isolated end portion on the side of the non-single-crystal semiconductor laminate member Q₀ to the marginal edge of the substrate 1 to cover the side surface of the non-single-crystal semiconductor laminate member Q₀.

The electrodes Fⱼ and Fⱼ₊₁ are isolated by an isolating portion Hⱼ. The electrodes Fⱼ₊₁ and F₀ are also isolated by an isolating portion Hₙ . The isolating portions Hᵢ may be simultaneously formed as grooves as is the case with the grooves Gᵢ.

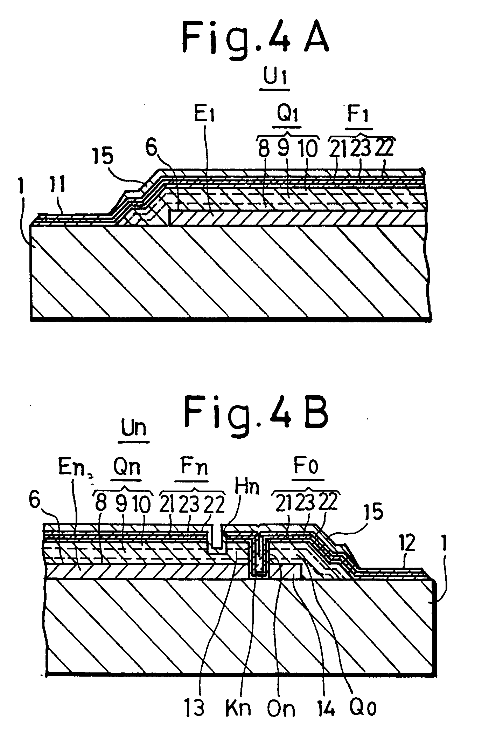

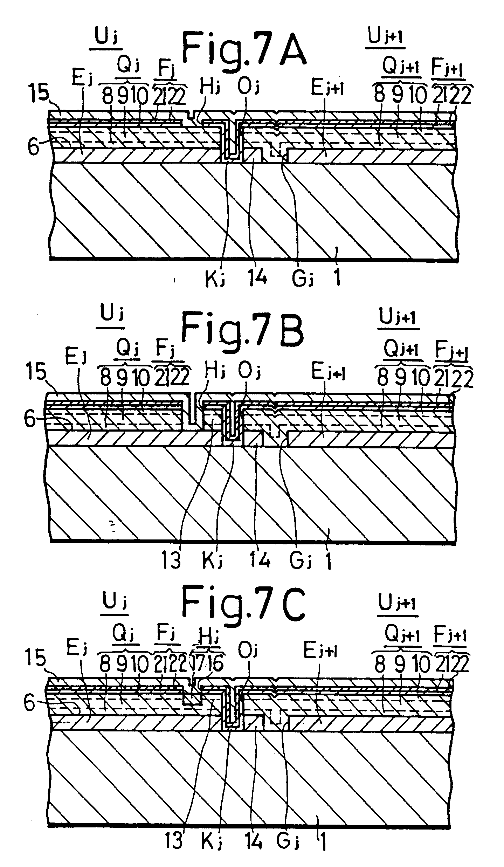

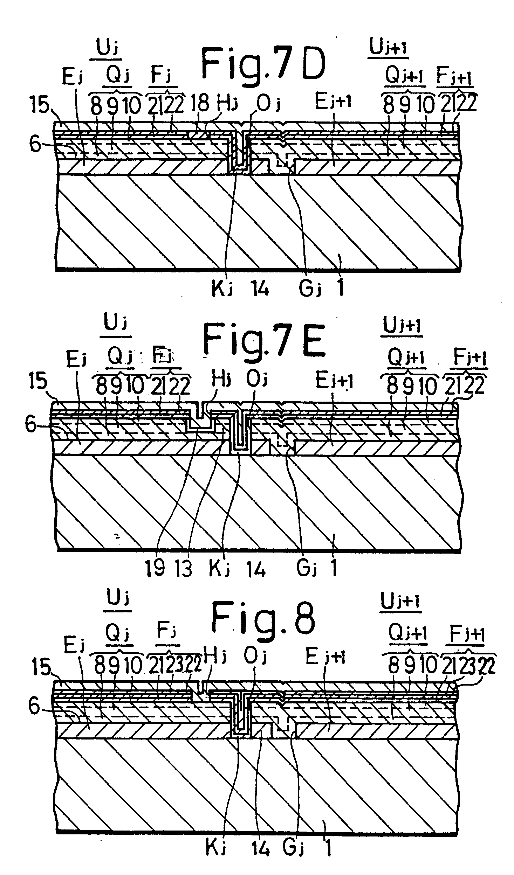

The electrode Fᵢ may be formed as a single layer as shown in Fig. 3 and may also be of the two-layer structure comprised of a layer 21 making contact with the non-single-crystal semiconductor laminate member Qᵢ and a layer 22 formed on the layer 21 as illustrated in Figs. 3B to D and 7. Also it is possible to employ such a three-layer structure as depicted in Fig. 8 which comprises the layers 21 and 22 and another layer 23 formed on the layer 2.

The electrode Fᵢ may be transparent. When the electrode Fᵢ is a transparent single layer, it is formed of a metallic oxide. In this case, it is required that the metal oxide be high in conductivity and in transmittance and, when forming the electrode Fᵢ, would not react with the material or impurity of the non-single-crystal semiconductor layer of the non-single-crystal semiconductor laminate member Qᵢ on the side of the electrode Fᵢ to form a layer which increases the contact resistance between the non-single-crystal semiconductor laminate member Qᵢ and the electrode Fᵢ or a layer of low transmittance. To meet such requirements, when the non-single-crystal layer of the non-single-crystal semiconductor laminate member Qᵢ on the side of the electrode Fᵢ is N-type, the electrode Fᵢ is formed of an indium oxide or metallic oxide consisting principally of the indium oxide, such as, for example, an indium oxide contaning 1 to 10 wt% of tin oxide. When the non-single-crystal layer of the non-single-crystal semiconductor to laminate layer Qᵢ on the side of the electrode Fᵢ is P-type, the electrode Fᵢ is formed of a tin oxide or metallic oxide consisting principally of the tin oxide. The electrode Fᵢ can be formed, for instance, 300 to 600 Å thick.

In the case where the electrode Fᵢ is transparent and has the two-layer structure composed of the layers 21 and 22, the layer 21 making contact with the non-single-crystal semiconductor laminate member Qᵢ may preferably be a layer formed of the tin oxide or consisting principally thereof, or a layer formed of the indium oxide or consisting principally thereof as described previously depending on whether the non-single-crystal semiconductor layer of the non-single-crystal semiconductor laminate member Qᵢ is P-type or N-type. In this case, it is preferable that when the layer 21 is the layer formed of the tin oxide or consisting principally thereof, the layer 22 be the layer formed of the indium oxide or consisting principally thereof and, when the layer 21 is the layer formed of the indium oxide or consisting principally thereof, the layer 22 be the layer formed the tin oxide or consisting principally thereof.

The electrode Fᵢ may be a reflective one when the substrate 1 and the electrode Eᵢ are light-transparent. When the electrode Fᵢ is the reflective electrode, it is possible to employ the two-layer structure comprising the layers 21 and 22, the three-layer structure comprising the layers 21, 22 and 23 or further multi-layer structure in addition to the single-layer structure as described previously.

Where the electrode Fᵢ is the two-layer structure made up of the layers 21 and 22, it is preferred that depending on whether the non-single-crystal semiconductor layer of the non-single-crystal semiconductor laminate member Qᵢ contacting the layer 21 is P-type or N-type, the layer 21 be the layer formed of the tin oxide or consisting principally thereof or the layer formed of the indium oxide or consisting principally thereof and the layer 22 be a reflective conductive layer as of silver or aluminum, as described previously.

When the electrode Fᵢ has the three-layer structure composed of the layers 21, 22 and 23, it is preferable that the layers 21 and 22 be such layers as mentioned above and the layer 23 a nickel layer.

The electrode Fᵢ need not always be reflective even if the substrate 1 and the electrode Eᵢ are light-transparent. In such a case, if the electrode has the two-layer structure comprised of the layers 21 and 22, it is preferred that the layer 21 be such a layer as mentioned above and the layer 22 a sublimable conductive layer formed of chromium or consisting principally thereof.

The electrode F₀ formed to extend on the non-single-crystal semiconductor laminate member Q₀ has the same structure as the abovesaid electrode Fᵢ.

The electrode Fⱼ₊₁ of the semiconductor element Uⱼ₊₁ (j=1, 2, ...(n-1)) is coupled with the electrode Eⱼ of the semoconductor element Uⱼ through a coupling portion Kⱼ.

The coupling portion Kⱼ extends from the position where the electrode Fⱼ₊₁ is opposite to the electrode Eⱼ to the region of the electrode Eⱼ opposite to the electrode Fⱼ₊₁, passing through a groove Oⱼ by which the non-single-crystal semiconductor laminate members Qⱼ and Qⱼ₊₁ are separated. Such a coupling portion Kⱼ is formed by an extension of the electrode Fⱼ₊₁ formed simultaneously with the electrode Fⱼ₊₁.

The electrode F₁ of the semiconductor element U₁ extends down to the surface of the substrate 1 as referred to previously and the extension constitutes an external connection terminal 11.

The electrode F₀ extending on the non-single-crystal semiconductor laminate member Q₀ is coupled with the electrode Eₙ of the semiconductor element Uₙ through a coupling portion Kₙ. In this case, the coupling portion Kₙ extends from the position where the electrode F₀ is opposite to the electrode Eₙ to the region of the electrode Eₙ opposite to the electrode F₀, passing through a groove Oₙ. Such a coupling portion Kₙ is an extension of the electrode F₀ formed simultaneously therewith. The electrode F₀ extends on the side surface of the non-single-crystal semiconductor laminate member Q₀ in the direction reverse from the electrode Fₙ to the marginal edge of the substrate 1, and the extending end portion forms a terminal 12 for external connection.

The isolated portion Hⱼ is formed to extend in the vertical direction in Fig. 1 to go down into the non-single-crystal semiconductor laminate member Qⱼ to form therein a region 13 underlying the electrode Eⱼ₊₁. The groove Oⱼ also extends across that portion of the electrode Eⱼ adjacent to the electrode Eⱼ₊₁ in the thickwise direction. Accordingly, the electrode Eⱼ has an isolated portion 14 on the side of the electrode Eⱼ₊₁.

The isolated portion Hₙ is formed to extend in the vertical direction in Fig. 1 to go down into the non-single-crystal semiconductor laminate member Qₙ to form therein the region 13 underlying the electrode F₀.

The groove Oₙ extends across that portion of the electrode Eₙ opposite side from the electrode F₀ in the thickwise direction. Accordingly, the electrode Eₙ has the isolated region 14 on the opposite side from the electrode Eₙ₋₁.

On the substrate 1 is formed a transparent antireflection and protective film 15 to cover the aforesaid semiconductors U₁ to Uₙ. In this case, however, the antireflection and protective film 15 does not extend on the extended portions of the electrodes F₁ and F0 forming the aforementioned external connection terminals 11 and 12, respectively.

The foregoing is a description of the arrangement of an embodiment of the photoelectric conversion device according to the present invention.

Next, a description will be given, with reference to Figs. 5A to G, of an embodiment of the photoelectric conversion device manufacturing method of the present invention.

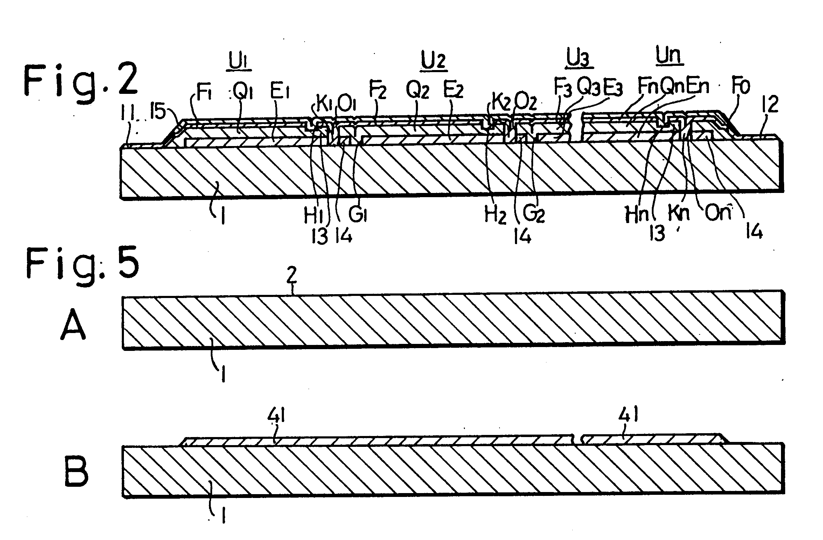

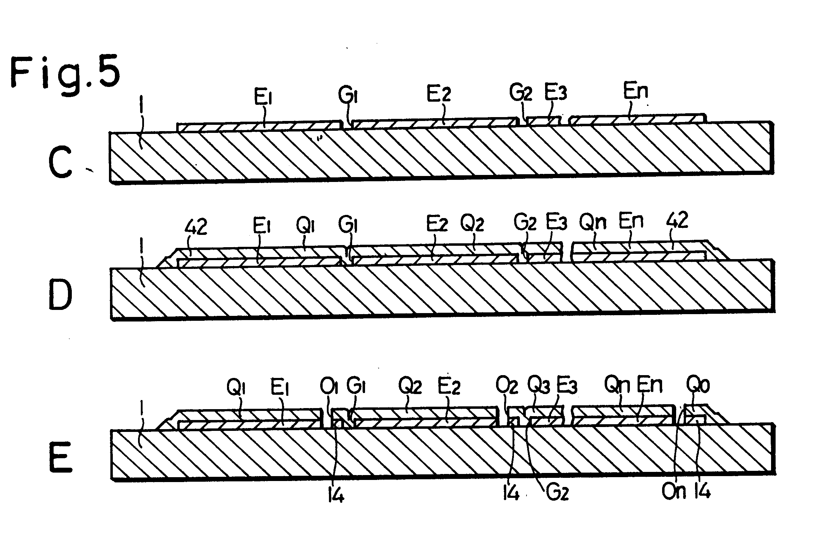

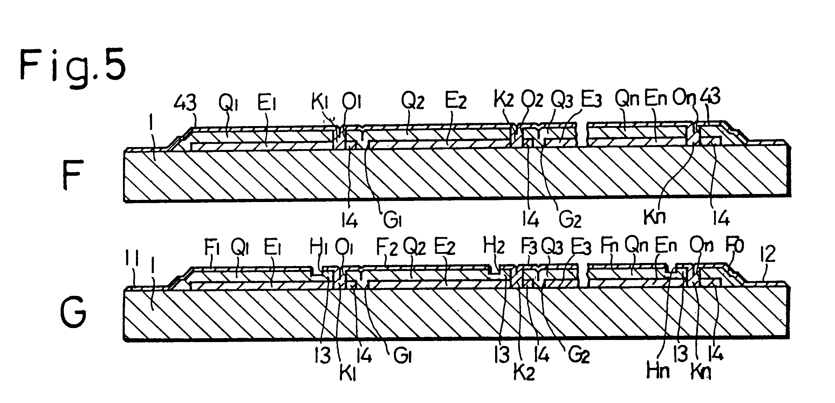

In Figs. 5A to G, parts corresponding to those in Figs. 1 and 2 are identified by the same reference numerals and characters and no detailed description thereof will be repeated.

The manufacturing method of the photoelectric conversion device shown in Figs. 5A to G is as follows:
The manufacture starts with the preparation of such a substrate 1 as described previously in respect of Figs. 1 and 2.

Then, as shown in Fig. 5B, the conductive layer 41 which will ultimately form the electrodes E₁ to Eₙ described previously in connection with Figs. 1 and 2 is formed by a known method on the substrate 1.

In the case where the electrodes E₁ to Eₙ are each formed to have the two-layer structure composed of the two layers 4 and 5 as described previously with regard to Fig. 3, the conductive layer 41 is made up of a layer which will ultimately serve as the layer 4 and another layer which ultimately serve as the layer 5, though neither shown nor described in detail. The former layer is first formed on the substrate 1 by a known method, for example, vapor deposition and then the latter layer is similarly formed thereon by a known method, for instance, vapor deposition. Next, the conductive layer 41 is scanned by a laser beam (not shown) having a diameter of 30 to 70 µm, typically, 40 µm, by which the aforementioned (n-1) grooves Gᵢ to Gₙ₋₁ are cut in the conductive layer 41 to form n electrodes E₁ to Eₙ which are separated from adjacent ones of them by the grooves G₁ to Gₙ₋₁, as shown in Fig. 5C. For this scanning, it is possible to employ a laser beam of a 1.06 µm wavelength from a YAG laser and a laser beam of a 0.488 or 0.512 µm wavelength from an argon laser.

The abovesaid laser beam scanning can be carried out in the air but may also be performed in the atmosphere of a gas which reacts with the conductive material of the layer 41 at high temperatures to spatter it from the substrate surface. In this case, the gas used may be hydrogen fluride (HF), hydrogen chloride (HCl) or Freon gas (CF₄, CHF₃, CClF₃ and like gases). In the case where the laser beam scanning takes place in the air, burrs are likely to form on the upper marginal edges of the groove Gⱼ. Accordingly, it is desirable that the laser beam scanning be followed by deburring through the use of the abovesaid gas or etching with an etchant such as hydrofluoric acid (HF), hydrochloric acid (HCl) or Freon liquids C₂F₃Cl₄C₂F₃Cl₃ and similar liquids. Moreover, it is possible to accomplish the laser beam scanning of the conductive layer 41 easily and accurately by the aid of a computer while monitoring through a video camera device.

Next, a non-single-crystal semiconductor layer formed by a known method, for example, low-pressure CVD on the substrate 1 to fill the grooves G₁ to Gₙ₋₁ and to cover the electrode E₁ to Eₙ as shown in Fig. 5D so that the regions of the layer 42 on the electrodes E₁ to Eₙ may be the non-single-crystal semiconductor laminate members Q₁ to Qₙ described previously in respect of Figs. 1 and 2.

Where the non-single-crystal semiconductor laminate members Q₁ to Qₙ are each formed as the three-layer structure consisting of the non-single-crystal semiconductor layers 8, 9 and 10 as described previously with regard to Fig. 3, non-single crystal semiconductor layers which will ultimately be used as the non-single-crystal layers 8, 9 and 10 respectively, are formed in this order through the use of a known method, for instance, the low-pressure CVD method, thereby providing the non-single-crystal semiconductor laminate member 42.

After this, the non-single-crystal semiconductor laminate members Q₁ to Qₙ are selectively removed by laser beam scanning to cut therein the aforementioned n grooves O₁ to Oₙ as shown in Fig. 5E. In this case, the groove Oᵢ (i=1, 2, ...n) can be formed to extend down to the insulating film 2 of the substrate 1 across the electrode Eᵢ as illustrated. In such a case, the region 14 of the electrode Eᵢ is isolated from the other regions. The laser beam scanning of the non-single-crystal semicondcutor laminate members Q₁ to Qₙ can take place in the air as is the case with the conductive layer 41. It is also possible to carry out the laser beam scanning in the atmosphere of a gas which reacts with the materials of the non-single-crystal semiconductor laminate member 42 and the electrodes E₁ to Eₙ at high temperatures to spatter them from the substrate surface. Also in this case, the gas used is hydrogen fluoride, hydrogen chloride or Freon gas. In the case where the laser beam scanning of the non-single-crystal semiconductor laminate members Q₁ to Qₙ is carried out in the air, it is desirable that the laser beam scanning be followed by deburring through the use of the aforesaid gas or etching with such etchants as mentioned previously. The abovesaid laser beam scanning can also be performed easily and accurately by the aid of a computer while monitoring through the video camera device.

The groove Oⱼ (j=1, 2, ...(n-1)) is formed at a position spaced a predetermined distance apart from the groove Gⱼ laterally thereof (on the left thereof in Fig. 5). The abovesaid predetermined distance is large as compared with the thickness of the non-single-crystal semiconductor laminate member 42. It is preferable, however, to minimize this distance. By the aid of a computer the groove Oⱼ can be provided in close proximity to the groove Gⱼ with high accuracy. This permits reduction of the area of the substrate 1 occupied by the region 14 of the electrode Eⱼ. It is desirable that the groove Oₙ be formed closely to the marginal edge of the electrode Eₙ on the opposite side from the electrode Eₙ₋₁ so that the region 14 of the electrode Eₙ may occupy less area of the substrate.

Next, a conductive layer 43, which will ultimately form the electrodes F₁ to Fₙ and F₀ referred to in respect to Figs. 1 and 2, is formed, for example by vapor deposition,on the substrate 1 to cover the non-single-crystal semiconductor laminate members Q₁ to Qₙ and to fill the grooves O₁ to Oₙ, forming coupling portions K₁ to Kₙ. In this case, the conductive layer 43 is formed to extend on the substrate 1 except both marginal portions in its lengthwise direction but it covers both marginal portions of the substrate 1 in its widthwise direction.

Next, the conductive layer 43 is selectively removed by laser beam scanning as is the case with the non-single-crystal semiconductor laminate members Q₁ to Qₙ. By this laser beam scanning there are formed in the conductive layer 43 n isolating portions H₁ to Hₙ, n electrodes F₁ to Fₙ isolated by the isolating portions H₁ to Hₙ₋₁, respectively, and opposite to the electrodes E₁ to Eₙ across the non-single-crystal semicondcutor laminate members Q₁ to Qₙ, respectively, and an elctrode F₀ isolated by the isolating portion Hₙ from the electrode Fₙ and opposite to electrode Eₙ. In this case, the laser beam scanning is carried out so that the electrode Fⱼ₊₁ may be linked with the electrode Eⱼ through the coupling portion Kⱼ and so that the electrode F₀ may be linked with the electrode Eₙ through the coupling portion Kₙ.

By the abovesaid laser beam scanning, the isolating portion Hᵢ (i= 1, 2, ...n) can be formed to extend into the non-single-crystal semiconductor laminate member Qᵢ.

As is the case with the conductive layer 41, the laser beam scanning of the conductive layer 43 can be effected in the air and may also be carried out in the atmosphere of a gas which reacts with the materials of the conductive layer 43 and the non-single-crystal semiconductor laminate members Q₁ to Qₙ at high temperatures to spatter them from the substrate surface. The gas used in this case may be hydrogen fluoride, hydrogen chloride or Freon gas.

Also in the case of performing the laser beam scanning of the conductive layer 43 in the air, it is desirable that the laser beam scanning be followed by deburring through the use of the aforesaid gas or etching using the aforesaid liquid as the etchant.

By the laser beam scanning for the conductive layer 43, the isolating portion Hᵢ can be provided in the form of a groove as illustrated.

The laser beam scanning of the conductive layer 43 can also be carried out easily and accurately by the aid of a computer while monitoring through the video camera device.

Further, the isolating portion Hᵢ is formed a predetermined distance apart from the groove Oᵢ laterally thereof (on the left thereof in the drawing). The abovesaid predetermined distance is large as compared with the thickness of the non-single-crystal semiconductor laminate member 43, but it may preferably be selected as small as possible. By the aid of a computer the isolating portion Hᵢ can be formed in close proximity to the groove Oᵢ with high precision. This allows reduction of the area of the substrate 1 occupied by the region 13 formed in the non-single-crystal semiconductor laminate member Qᵢ.

Next, a transparent antireflection and protective film 15 is formed by a known method on the substrate to cover the electrodes F₁ to Fₙ and F₀ and the isolating portion H₁ as shown in Fig. 5G.

In the manner described above, the photoelectric conversion device of the present invention, shown in Figs. 1 and 2, is manufactured.

The above is a description of an embodiment of the present invention and an example of its manufacturing method.

According to the photoelectric conversion device of Figs. 1 and 2, when light (not shown) is incident thereon from the side of the substrate 1 or the electrodes F₁ to Fₙ each semiconductor elements Uᵢ (i=1, 2, ...n) carries out photoelectric conversion to generate photovoltage across its electrodes Eᵢ and Fᵢ.

The electrode Fⱼ₊₁ (j= 1, 2, ...(n-1)) of the semiconductor element Uⱼ₊₁ is linked with the electrode Eⱼ of the semiconductor element Uⱼ through the coupling portion Kⱼ and the electrode F₁ of the semiconductor element U₁ is connected to an external connection terminal 11 and the electrode Eₙ of the semiconductor element Uₙ is connected to an external connection terminal 12 through the coupling portion Kₙ and the electrode F₀.

Accordingly, the semiconductor elements U₁ to Uₙ are sequentially connected in series through the coupling portions K₁ to Kₙ₋₁ and connected to the external connection terminals 11 and 12. Consequently, upon incidence of light, there is developed across the external connection terminals 11 and 12 the photovoltage that is equal to the sum of voltage produced by the semiconductor elements U₁ to Uₙ.

In addition, by forming the electrodes Eᵢ and Fᵢ of the semiconductor element Uᵢ as the reflective electrodes as described previously in respect of Fig. 3, incident light can efficiently be utilized by the semiconductor Uᵢ, providing for increased photovoltage per unit area of the substrate 1.

By virtue of the fact that the layer of the electrode Eᵢ contacting the non-single-crystal semiconductor laminate member Qᵢ is formed as the aforesaid metal oxide layer, an excellent ohmic contact can be made between the electrode Eᵢ and the non-single-crystal semiconductor laminate member Qᵢ, so that high photovoltage can be obtained from the semiconductor element Uᵢ with practically no loss.

These features are made more marked by virtue of the fact that, in accordance with the teachings of the present invention, the layer of the electrode Eᵢ contacting the non-single-crystal semiconductor laminate member Qᵢ is formed of a tin oxide or a metallic oxide consisting principally thereof, or an indium oxide or a metallic oxide consisting principally thereof, depending on whether the non-single-crystal semiconductor layer of the non-single-crystal semiconductor laminate member Qᵢ contacting the electrode Eᵢ is P-type or N-type.

Where the groove 0ⱼ cut in the non-single-crystal semiconductor laminate member Qⱼ is extended into the electrode Eⱼ as illustrated, the coupling portion Kⱼ extending from the electrode Fⱼ₊₁ makes side-contact with the electrode Eⱼ and hence makes good ohmic contact therewith, ensuring to obtain large electromotive force across the external connection terminals 11 and 12 with no appreciable loss. This is particularly the case in the practice of the present invention where the coupling portion Kⱼ and the electrode Eⱼ are linked with each other through their metal oxide layers.

Since the isolating portion Hⱼ is formed to extend into the non-single-crystal semiconductor laminate member Qⱼ as illustrated, substantially no leakage occurs through the non-single-crystal semiconductor laminate members Qⱼ between the electrode Eⱼ and Fⱼ₊₁, ensuring to obtain large electromotive force across the external connection terminals 11 and 12.

In the embodiment of Figs. 1 and 2, the non-single-crystal semiconductor laminate member Q₁ of the semiconductor element U₁ is formed on the electrode E₁ to extend onto the substrate 1 passing on the side surface of the electrode E₁ on the opposite side from the non-single-crystal semiconductor laminate member Q₂, and the electrode F₁ is formed on the non-single-crystal semiconductor laminate member Q₁ to extend onto the substrate 1 passing on the side surface and the extended portion is used as the external connection terminal 11. With such an arrangement, the series circuit of the semiconductor elements U₁ to Uₙ can easily be connected at one end to the external connection terminal 11. This permits simplification of the construction of photoelectric conversion device as a whole.

Further, in the embodiment of Figs. 1 and 2, the non-single-crystal semiconductor laminate member Qₙ is formed to extend on the side surface of the electrode Eₙ on the opposite side from the electrode Eₙ₋₁ towards the substrate 1. The electrode F₀ is formed on the non-single-crystal semiconductor laminate member Qₙ to extend to the substrate surface and the electrode F₀ is coupled with the electrode Eₙ through the coupling portion Kₙ. And the extended portion of the electrode F₀ on the substrate 1 is used as the external connection terminal 12. Accordingly, the series circuit of the semiconductor elements U₁ to Uₙ can easily be connected at one end to the external connection terminal 12, permitting simplification of the overall structure of the photoelectric conversion device.

A description will be given of other embodiments of the photoelectric conversion device of the present invention.

In the embodiment of the photoelectric conversion device of the present invention depicted in Figs. 1 to 3, the groove Oⱼ extends across the electrode Eⱼ to reach the substrate 1, and the coupling portion Kⱼ makes contact only with the side of the electrode Eⱼ exposed to the groove Oⱼ.

In other embodiment of the photoelectric conversion device of the present invention, however, as shown in Fig. 6A, the groove Oⱼ is not extended into the electrode Eⱼ and the coupling portion Kⱼ is formed to make contact only with the top of the electrode Eⱼ exposed to the groove Oⱼ.

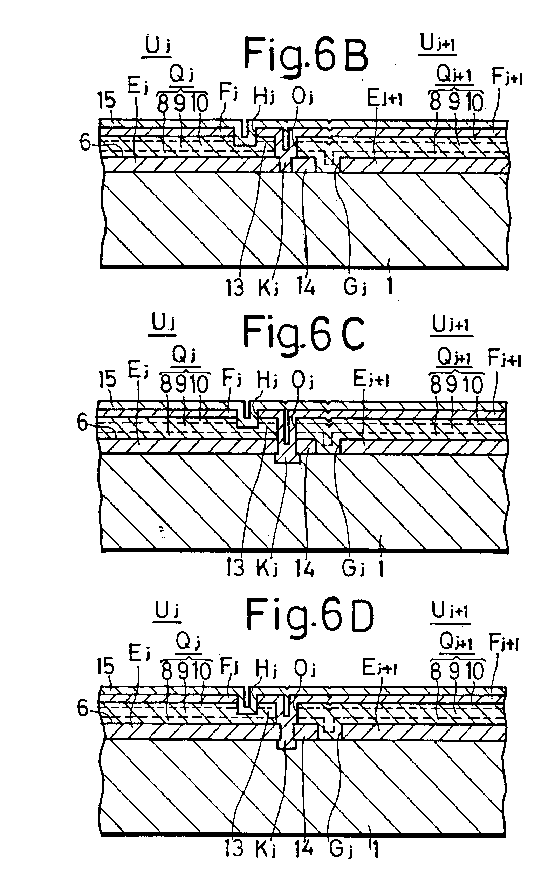

Further, as shown in Fig. 6B, the width of the groove Oⱼ in the electrode Eⱼ is made smaller than in the non-single-crystal semiconductor laminate member Qⱼ and the coupling portion Kⱼ is formed to make contact with the top and side of the electrode Eⱼ exposed to the groove Oⱼ.

Moreover, according to another embodiment, as shown in Fig. 6C the groove Oⱼ is extended into the substrate 1 with a greater width than in the electrode Eⱼ, and the coupling portion Kⱼ is formed to make contact with the side and bottom of the electrode Eⱼ exposed to the groove Oⱼ.

According to another embodiment, as shown in Fig. 6D, the groove Oⱼ is extended across the electrode Eⱼ as in the case of Fig. 6B and into the substrate 1 as in the case of Fig. 6C, and the coupling portion Kⱼ is formed to make contact with the top, side and bottom of the electrode Eⱼ exposed to the groove Oⱼ.

In the embodiments illustrated in Figs. 6A to D, the groove Oⱼ can easily be formed by the same laser beam scanning as that for the non-single-crystal semiconductor laminate member Qⱼ described previously in respect of Fig. 5 but, in this case, the intensity of the laser beam is adjusted suitably.

It will be seen that any of the structures of the embodiments provided with the grooves shown in Figs. 6A to D possesses the same advantages as are obtainable with the embodiment of Figs. 1 to 3, though not described in detail.

In the embodiment of the photoelectric conversion device shown in Figs. 1 to 3, the electrodes Fⱼ and Fⱼ₊₁ of the semiconductor elements Uⱼ and Uⱼ₊₁ are isolated by the isolating portion provided in the form of a groove and the isolating portion Hⱼ extends into the non-single-crystal semiconductor laminate member Qᵢ. The embodiment of Fig. 7B corresponding to Fig. 3 is identical in construction with the embodiment of Figs. 1 to 3 except that the isolating portion Hⱼ extends across the non-single-crystal semiconductor laminate member Qᵢ. Such isolating portions H₁ to Hₙ can easily be formed by adjusting the scanning speed and/or power of the laser beam in the laser beam scanning for the conductive layer 43 described previously in connection with Fig. 5.

Further, the embodiment of Fig. 7C corresponding to Fig. 3 photoelectric conversion device of the present invention is identical in construction with the embodiment of Figs. 1 to 3 except that the isolating portion Hⱼ consists of the groove 16 defined between the electrodes Fⱼ and Fⱼ₊₁ and the oxide 17 of the non-single-crystal semiconductor forming the non-single-crystal semiconductor laminate member Qⱼ, which is formed in the upper half portion thereof.

Such isolating portions H₁ to Hₙ can easily be formed by carrying out in an oxygen atmosphere the laser beam scanning for the conductive layer 43 described previously with respect to Fig. 5.

Likewise, the embodiment of Fig. 7D is identical in constructions with the embodiment of Figs. 1 to 3 except that the isolating portion Hⱼ is formed by an oxide 18 which results from oxidation of the conductive material forming the electrodes Fⱼ and Fⱼ₊₁ and separates them as shown. Such isolating portions H₁ to Hₙ can easily be formed by the same laser beam scanning as that employed for the third embodiment of Fig. 7C.

The embodiment of Fig. 7A is also identical in construction with the embodiment of Figs. 1 to 3 except that the isolating portion Hⱼ is formed by the groove 16 which hardly extends into the non-single-crystal semiconductor laminate member Qⱼ but separates the electrodes Eⱼ and Eⱼ₊₁ as shown. Such isolating portion H₁ to H_{N} can easily be formed by adjusting the scanning speed and/or power of the laser beam in the laser beam scanning as in the embodiment of Fig. 5.

Another embodiment of Fig. 7E is identical in construction with the embodiment of Figs. 1 to 3 except that the isolating portion Hⱼ has such a structure that an oxide layer is formed on the interior surface of the groove described previously with respect to Fig. 3.

Such an isolating portion Hⱼ can easily be formed by perfoming the laser beam scanning for the conductive layer 43 mentioned previously with regard to Fig. 5 in the oxygen atmosphere as in the embodiment of Fig. 7D.

It is evident that all the arrangements of the embodiments having the isolating portions H₁ to Hₙ, shown in Figs. 7A to E, have the same features as those of the embodiment of Figs. 1 to 3, though not described in detail.

In the embodiment of Figs. 1 to 3, the series circuit of the semiconductor elements U₁ to Uₙ constituting one photoelectric conversion device on the substrate 1 is connected at one end to the external connection terminal 11, which is formed by the extended portion of the electrode E₁ of the semiconductor element U₁ on the substrate 1, and connected at the other end to the external connection terminal 12 which is formed by the extended portion of the electrode F₀ on the substrate 1 and connected to the electrode Eₙ through the coupling portion Kₙ.

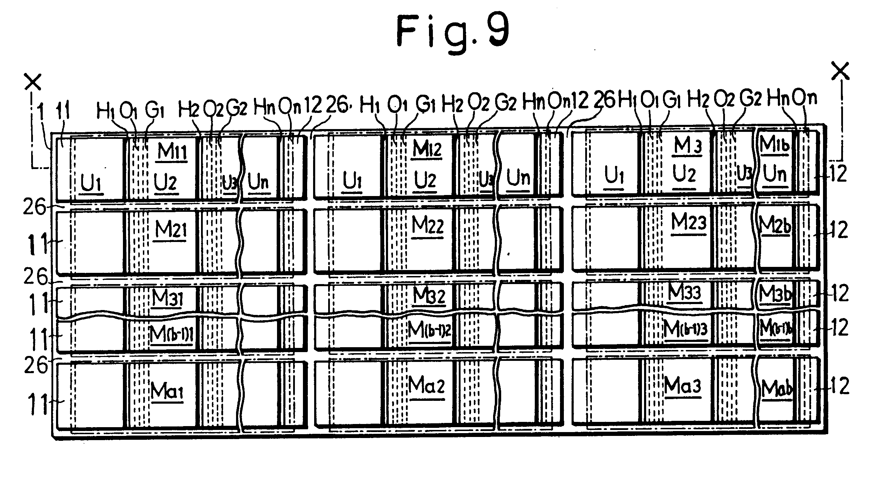

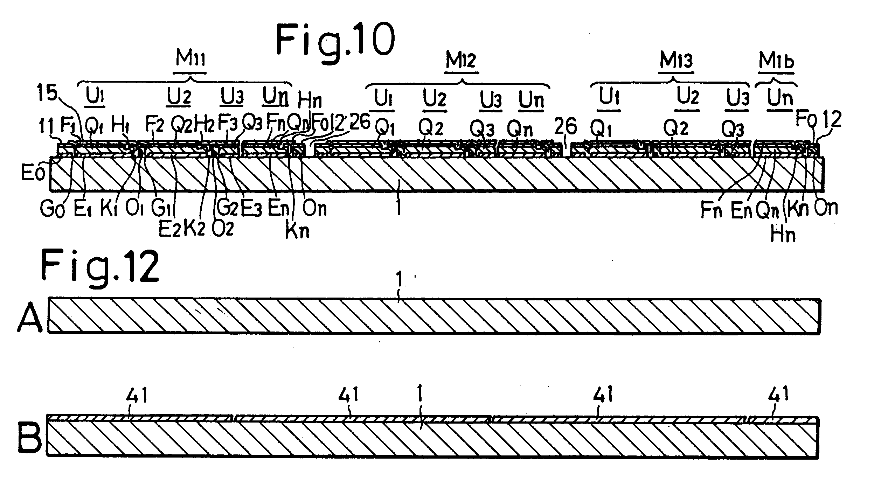

In another embodiment of the present invention, however, a plurality a x b of such photoelectric conversion devices, each made up of the n semiconductor elements U₁ to Uₙ connected in series as shown in Figs. 1 and 2, are arranged in the form of a matrix consisting of a rows and b columns as illustrated in Figs. 9 and 10 corresponding to Figs. 1 and 2. In Figs. 9 and 10 reference character Mᵣₛ (r=1, 2,... a and s=1, 2,...b) indicates each photoelectric conversion device disposed at one of the intersections of rows and columns. The photoelectric conversion devices M₁₁ to M_{1b}, M₂₁ to M_{2b}, ... and Mₐ₁ to M_{ab} are isolated by grooves 26 from adjacent ones of them.

In the embodiment illustrated in Figs. 9 and 10, the photoelectric conversion device Mᵣₛ is identical in construction with the photoelectric conversion device of the embodiment of Figs. 1 to 3 except in the following points:

As shown in Fig. 11A, an electrode E₀ similar to the electrodes E₁ to Eₙ is formed on the substrate 1 on the side of the electrode E₁ of the semiconductor element U₁ on the opposite side from the electrode E₁ and the electrode E₀ is isolated by a groove G₀ similar to those G₁ to Gₙ₋₁.

Further, the non-single-crystal semiconductor laminate member Q₁ of the semiconductor element U₁ does not extend from the electrode E₁ to the substrate surface but instead it extends across the groove G₀ to the marginal edge of the electrode E₀.

The electrode F₁ of the semiconductor element U₁, which is formed to cover the non-single-crystal semiconductor laminate member Q₁ and extend to the substrate 1 in the first embodiment, is formed to extend to the marginal edge of the non-single-crystal semiconductor laminate member Q₁ correspondingly. And the external connection terminal 11 is formed by the end portion of the electrode F₁ on the non-single-crystal semiconductor laminate member Q₁ on the opposite side from the electrode F₂.

Moreover, as shown in Fig.11B, the non-single-crystal semiconductor laminate member Qₙ of the semiconductor element Uₙ is formed to extend to the marginal edge of the electrode Eₙ.

The electrode F₀, though formed to cover the non-single-crystal semiconductor laminate member Qₙ and to extend to the substrate 1 in the embodiment of Figs. 1 to 3, extends to the marginal edge of the non-single-crystal semiconductor laminate member Qₙ correspondingly. And the external connection terminal 12 is formed by the end portion of the electrode F₀ on the non-single-crystal semiconductor laminate member Qₙ on the opposite side from the electrode Fₙ.

The above is a description of the abovesaid another embodiment of the photoelectric conversion device of the present invention.

The photoelectric conversion device of such a construction can be obtained by a manufacturing method similar to that employed for the fabrication of the photoelectric conversion device of the embodiment of Figs. 1 to 3.

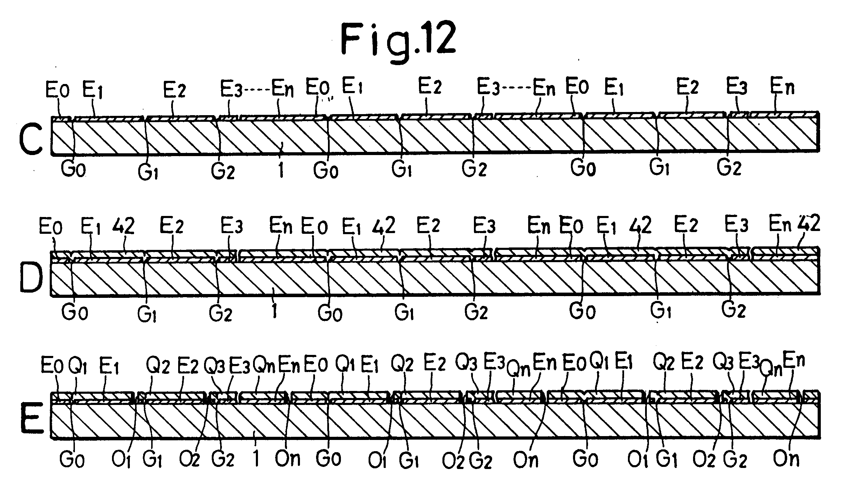

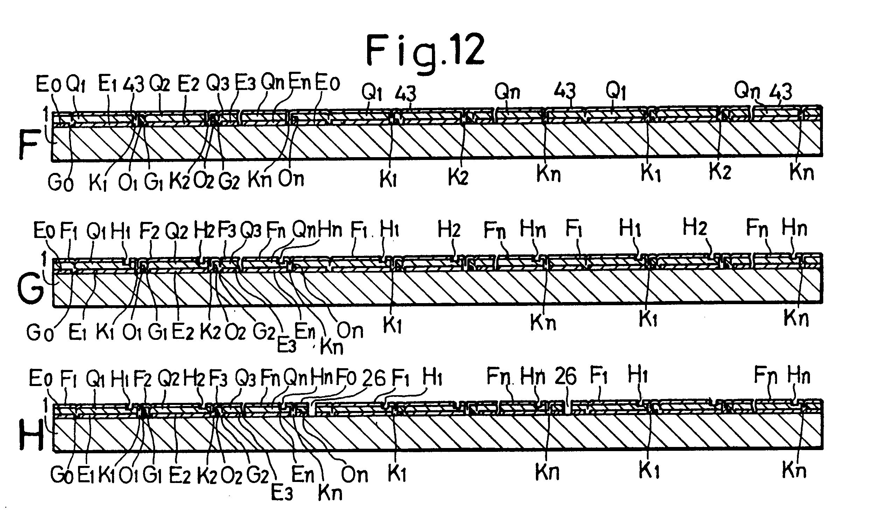

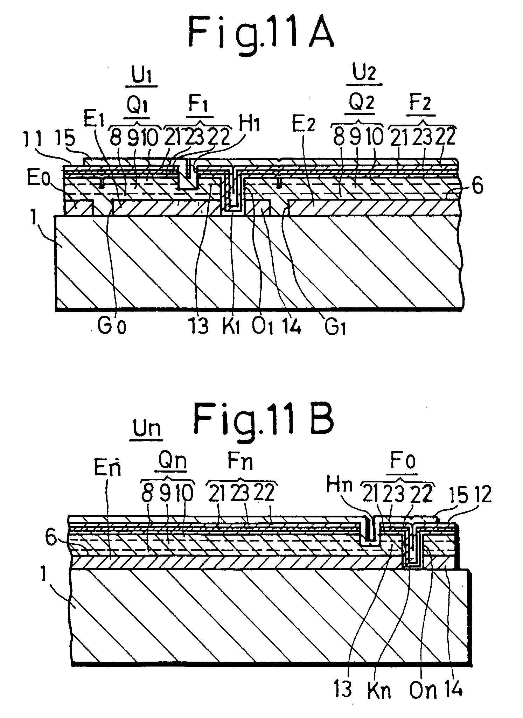

That is, as shown in Figs. 12A to G corresponding to Figs. 5A to G, a x b photoelectric conversion devices M₁₁ to M_{1b}, M₂₁ to M_{2b}, ... and Mₐ₁ to M_{ab} are formed on the substrate 1 by a sequence of steps similar to those shown in Figs. 5A to G, though not described in detail. Next, as shown in Fig. 12H, the grooves 26 are formed by the same laser beam scanning as described previously in respect of Fig. 4.

Next, the light transparent antireflection and protective film 15 (not shown) is formed.

In this way, the structure of the embodiment referred to previously in conjunction with Figs. 9 and 10 is obtained.

The above is a description of the abovesaid another embodiment and its manufacturing method.

The photoelectric conversion device of Figs. and 10 is identical in construction with the embodiment of Figs. 1 to 3 except in the abovesaid points, and hence presents the same advantages as those obtainable with the embodiment of Figs. 1 to 4, though not described in detail.

Moreover, according to the embodiment of Figs. 9 and 10, the photoelectric conversion devices M₁₁ to M_{1b}, M₂₁ to M_{2b}, ...and Mₐ₁ to M_{ab} are formed on the substrate 1 and separated by the grooves 26. If the substrate 1 is formed by a flexible, insulating sheet-like member, it can easily be severed at the positions of the grooves 26 into a x b independent photoelectric conversion devices.

Incidentally, the embodiment of Figs. 9 and 10 can also be modified and varied in the same manner as in the second to ninth embodiments of Figs. 6 to 8 which are modifications and variations of the embodiment of Figs. 1 to 4.

While in the foregoing embodiments of the present invention the groove Oⱼ formed in the non-single-crystal semiconductor laminate members Qⱼ is shown to be a groove which continuously extends in the vertical direction to completely isolate the non-single-crystal semiconductor laminate memers Qⱼ and Qⱼ₊₁ mechanically, the groove Oⱼ may also be formed to discontinuously extend in the vertical direction so that the non-single-crystal semiconductor laminate members Qⱼ and Qⱼ₊₁ may not completely be isolated by the groove Oⱼ from each other.

## Claims

1. A photoelectric conversion device comprising an insulating substrate (1) and a plurality of adjacent series-connected photoelectric elements Uᵢ(i=1,2,...n) each of which comprises a silicon based non-single crystal semiconductor layer Qᵢ having formed therein at least one semiconductor junction and first and second electrodes Eᵢ, Fᵢ which sandwich said semiconductor layer Qᵢ therebetween so that said first electrode Eᵢ makes contact with the surface of a first conductivity type portion of the semiconductor layer Qᵢ and said second electrode Fᵢ makes contact with the surface of a second conductivity type portion of the semiconductor layer Qᵢ, said second conductivity type being of opposite conductivity to said first conductivity type, and said photoelectric elements Uᵢ being series-connected with one another by virtue of one electrode Fⱼ₊₁ (j=1,2...(n-1)) of each element Uⱼ₊₁ having an integrally formed coupling portion Kⱼ in contact with the other electrode Eⱼ of another element Uⱼ, characterized in that said first and second electrodes Eᵢ, Fᵢ comprise electrically-conductive metal oxide layers contacting the respective surfaces of the semiconductor layer Qᵢ, and the metal oxide layer contacting the P-type surface of the semiconductor layer is tin oxide or a metal oxide consisting principally of tin oxide, and the metal oxide layer contacting the N-type surface of the semiconductor layer is indium oxide or a metal oxide consisting principally of indium oxide.

2. A photoelectric conversion device according to claim 1 wherein:
the semiconductor element Uᵢ (i=1, 2,...n) comprises a non-single-crystal semiconductor laminate member Qᵢ formed on the first electrode Eᵢ and having formed therein at least one semiconductor junction, and the second electrode Fᵢ is formed on the non-single-crystal-semiconductor laminate member Qᵢ in opposing relationship to the first electrode Eᵢ;
the coupling portion Kⱼ is formed as an extension of the second electrode Fⱼ₊₁;
the second electrode Fᵢ and the coupling portion Kⱼ comprise an electrically conductive metal oxide substantially different to the electrically conductive metal oxide of the first electrode Eⱼ.

3. A photoelectric conversion device according to claim 2 wherein the first electrode Eᵢ and/or the second electrode Fᵢ comprises a single metal oxide layer.

4. A photoelectric conversion device according to claim 2 wherein the first electrode Eᵢ and/or the second electrode Fᵢ comprises a multilayer structure (4,5).

5. A photoelectric conversion device according to claim 4 wherein one of said first and second electrodes Eᵢ, Fᵢ is arranged to be light transparent, and the other of said first and second electrodes Eᵢ, Fᵢ includes a light reflective layer.

6. A photoelectric conversion device according to claim 5 wherein said light reflective layer comprises a metallic layer.

7. A photoelectric conversion device according to claim 5 or 6 wherein the interface between the non-single-crystal semiconductor laminate member Qᵢ and that one of said first and second electrodes which includes a light reflective layer has irregularities defining a diffuse reflection surface.

8. A photoelectric conversion device according to any of claims 2 to 7, wherein the non-single-crystal semiconductor laminate member Qᵢ is partly or wholly formed of Si, SiₓC₁₋ₓ (0< x < 1), SiₓGe₁₋ₓ (0 < x < 1) or Si₃N₄₋ₓ (0< x < 4).

9. A photoelectric conversion device according to any of claims 2 to 8, wherein the non-single-crystal semiconductor laminate member Qᵢ comprises a first non-single-crystal semiconductor layer (8) of a first conductivity type, an I-type second non-single-crystal semiconductor layer (9) formed on the first non-single-crystal semiconductor layer, and a third non-single-crystal semiconductor layer (10) of a second conductivity type opposite to the first conductivity type formed on the second non-single-crystal semiconductor layer, and wherein the semiconductor junction is a PIN junction.

10. A photoelectric conversion device according to claim 9, wherein the substrate and the first electrode Eᵢ are light-transparent, and wherein the first non-single-crystal semiconductor layer (8) contacts the first electrode Eᵢ and has a wider energy gap than do the second and third non-single-crystal semiconductor layers.

11. A photoelectric conversion device according to claim 9, wherein the substrate and the first electrode Eᵢ are light-transparent, and wherein the first electrode Eᵢ contacts the first semiconductor layer and the first and third non-single-crystal semiconductor layers have a wider energy gap than does the second non-single-crystal semiconductor layer.

12. A photoelectric conversion device according to claim 9, wherein the second electrode Fᵢ is light-transparent, and wherein the third non-single-crystal semiconductor layer (10) contacts the second electrode Fᵢ and has a wider energy gap than do the first and second non-single-crystal semiconductor layers.

13. A photoelectric conversion device according to claim 9, wherein the second electrode Fᵢ is light-transparent and contacts the third semiconductor layer, and wherein the first and third non-single-crystal semiconductor layers have a wider energy gap than does the second non-single-crystal semiconductor layer.

14. A photoelectric conversion device according to any of claims 2 to 13, wherein the first electrode Eⱼ and the first electrode Eⱼ₊₁ are separated by a first groove Gⱼ, wherein the second electrode Fⱼ₊₁ extends on the non-single-crystal semiconductor laminate member Qⱼ in opposing relation to the first electrode Eⱼ, wherein a second groove Oⱼ is cut in the non-single-crystal semiconductor laminate member Qᵢ to extend between the second electrode Fⱼ₊₁ and the first electrode Eⱼ, and wherein the coupling portion Kⱼ extends into the second groove Oⱼ.

15. A photoelectric conversion device according to claim 14, wherein the second groove 0ⱼ extends into the first electrode Eⱼ.

16. A photoelectric conversion device according to claim 15, wherein the second groove Oⱼ extends into the first electrode Eⱼ with a smaller width than it extends into the non-single-crystal semiconductor laminate member Qⱼ^{.}

17. A photoelectric conversion device according to claims 15 or 16, wherein the second groove Oⱼ extends through the first electrode Eⱼ and into the substrate where it has a width greater than its width in the first electrode Eⱼ.

18. A method of manufacturing a photoelectric conversion device comprising forming a plurality of spaced apart first electrodes (Eᵢ) on an insulating substrate (1), forming a silicon based non-single crystal semiconductor layer (42) having a first conductivity type portion overlying all of the spaced-apart first electrodes (Eᵢ), said semiconductor layer (42) having formed therein at least one semiconductor junction and having a second, opposite conductivity type portion remote from said first conductivity type portion, dividing said semiconductor layer (42) so as to define a plurality of separate semiconductor layers (Qᵢ) each associated with a respective one of said plurality of first electrodes (Eᵢ) and so as to expose a portion of each of the respective first electrodes, forming a second electrode layer (43) overlying the second conductivity type portions of all of the separate semiconductor layers (Qᵢ) and contacting the exposed portions of the first electrodes (Eᵢ), and dividing the second electrode layer (43) so as to define a plurality of separate second electrodes (Fᵢ) each associated with a respective first electrode (Eᵢ) and a respective one of the separate semiconductor layers (Qᵢ) so as to constitute therewith a photoelectric element (Uᵢ), each photoelectric element being series connected to adjacent like photoelectric elements by providing one electrode (Fⱼ₊₁) of each element (Uⱼ₊₁) with an integrally formed coupling portion Kⱼ in contact with the other electrode Eⱼ of another element, characterized in that the first and second electrode layers are formed as electrically-conductive metal oxide layers, and the metal oxide layer contacting the P-type surface of the semiconductor layer is tin oxide or a metal oxide consisting principally of tin oxide, and the metal oxide layer contacting the N-type surface of the semiconductor layer is indium oxide or a metal oxide consisting principally of indium oxide.

19. A method according to claim 18, said method comprising the steps of:
forming on the substrate (1) a first conductive metal oxide layer (41);
subjecting the first conductive layer (41) to first laser beam scanning to form therein (n-1) (where n is an integer larger than 2) sequentially arranged first grooves G₁ to Gₙ₋₁ and n sequentially arranged first electrodes E₁ to Eₙ each comprising a conductive metal oxide layer, separated by the first grooves G₁ to Gₙ₋₁, respectively;
forming the non-single-crystal semiconductor laminate layer (42) on the substrate (1), the semiconductor layer (42) having formed therein at least one semiconductor junction to cover the first grooves G₁ to Gₙ₋₁ and the first electrodes E₁ to Eₙ so that those regions of the non-single-crystal semiconductor laminate member on the electrodes E₁ to Eₙ define non-single-crystal semiconductor laminate members Q₁ to Qₙ, respectively;
subjecting the non-single-crystal semiconductor laminate members Q₁ to Qₙ to second laser beam scanning to form therein (n-1) sequentially arranged second grooves 0₁ to 0ₙ₋₁ to expose therethrough the first electrodes E₁ to Eₙ₋₁ to the outside, respectively;
forming the second conductive layer (43) to extend continuously over the non-single-crystal semiconductor laminate members Q₁ to Qₙ and into the grooves 0₁ to 0ₙ₋₁ to provide coupling portions K₁ to Kₙ₋₁ which are connected to the first electrodes E₁ to Eₙ₋₁ through the grooves 0₁ to 0ₙ₋₁; and
subjecting the second conductive layer (43) to third laser beam scanning to form therein isolating portions H₁ to Hₙ₋₁ on the non-single-crystal semiconductor laminate members Q₁ to Qₙ₋₁, respectively, and to form the second electrodes as n sequentially arranged electrodes F₁ to Fₙ each of which are isolated by the isolating portions H₁ to Hₙ₋₁, respectively, and opposite the first electrodes E₁ to Eₙ through the non-single-crystal semiconductor laminate members Q₁ to Qₙ, respectively.

20. A method according to claim 19 wherein the second groove 0ⱼ (j=1, 2,...(n-1)) is formed to extend into or through the first electrode Eⱼ so that the coupling portion Kⱼ may be connected with an increased area of the first electrode Eⱼ.

21. A method according to claim 19 or 20 wherein at least one of the first, second and third laser beam scanning steps is performed in the air and is followed by treatment using a gas, such as hydrogen fluoride (HF), hydrogen chloride (HCl) or a fluorocarbon gas (CF₄, CFH₃, CClF₂, or the like), or a liquid, such as hydrofluoric acid (HF) hydrochloric acid (HCl) or a fluorocarbon liquid (C₂F₃Cl₄, C₂F₃Cl₃ or the like).

## Patentansprüche

1. Photovoltaischer Wandler mit einem isolierenden Substrat (1) und mehreren jeweils benachbarten, in Reihe geschalteten photoelektrischen Elementen Uᵢ (i = 1, 2, ..., n), von denen jedes eine nichteinkristalline Halbleiterschicht Q₁ auf Siliziumbasis, in der mindestens ein Halbleiterübergang ausgebildet ist, sowie eine erste und eine zweite Elektrode Eᵢ, Fᵢ aufweist, die die Halbleiterschicht Qᵢ zwischen sich so einbetten, daß die erste Elektrode Eᵢ zur Oberfläche eines Bereichs der Halbleiterschicht Qᵢ von erstem Leitungstyp kontaktiert und die zweite Elektrode Fᵢ zur Oberfläche eines Bereichs der Halbleiterschicht Qᵢ vom zweiten Leitungstyp kontaktiert, wobei der zweite Leitungstyp dem ersten Leitungstyp entgegengesetzt ist und wobei die photoelektrischen Elemente Uᵢ miteinander dadurch in Reihe geschaltet sind, daß eine Elektrode Fⱼ₊₁ (j = 1, 2, ..., (n-1)) jedes Elements Uⱼ₊₁ einen integral mit ihr ausgebildeten Kopplungsabschnitt Kⱼ aufweist, der in Kontakt mit der anderen Elektrode Eⱼ eines anderen Elements Uⱼ steht, **dadurch gekennzeichnet**, daß die erste und die zweite Elektrode Eᵢ, Fᵢ elektrisch leitende Metalloxidschichten aufweisen, die die jeweiligen Flächen der Halbleiterschicht Qᵢ kontaktieren, und daß die die Halbleiterschichtfläche vom p-Typ kontaktierende Metalloxidschicht aus Zinnoxid oder einem im wesentlichen Zinnoxid enthaltenden Metalloxid besteht und die die Halbleiterschichtfläche vom n-Typ kontaktierende Metalloxidschicht aus Indiumoxid oder einem im wesentlichen Indiumoxid enthaltenden Metalloxid besteht.

2. Photovoltaischer Wandler nach Anspruch 1, bei dem
- das Halbleiterelement Uᵢ (i = 1, 2, ..., n) ein auf der ersten Elektrode Eᵢ ausgebildetes nichteinkristallines Halbleiterlaminatteil Qᵢ aufweist, in dem mindestens ein Halbleiterübergang ausgebildet ist, und die zweite Elektrode Fᵢ auf dem nichteinkristallinen Halbleiterlaminatteil Qᵢ der ersten Elektrode Eᵢ gegenüberstehend angeordnet ist;
- der Kopplungsabschnitt Kⱼ als Verlängerung der zweiten Elektrode Fⱼ₊₁ ausgebildet ist;
- die zweite Elektrode Fᵢ und der Kopplungsabschnitt Kⱼ ein elektrisch leitendes Metalloxid aufweisen, das sich im wesentlichen vom elektrisch leitenden Metalloxid der ersten Elektrode Eⱼ unterscheidet.

3. Photovoltaischer Wandler nach Anspruch 2, bei dem die erste Elektrode Eᵢ und/oder die zweite Elektrode Fᵢ eine einzelne Metalloxidschicht aufweisen.

4. Photovoltaischer Wandler nach Anspruch 2, bei dem die erste Elektrode Eᵢ und/oder die zweite Elektrode Fᵢ eine Mehrschichtstruktur (4, 5) aufweisen.

5. Photovoltaischer Wandler nach Anspruch 4, bei dem die erste oder die zweite Elektrode Eᵢ, Fᵢ lichtdurchlässig ausgebildet ist, und die andere Elektrode von dieser ersten und zweiten Elektrode Eᵢ, Fᵢ eine lichtreflektierende Schicht aufweist.

6. Photovoltaischer Wandler nach Anspruch 5, bei dem die lichtreflektierende Schicht eine Metallschicht aufweist.

7. Photovoltaischer Wandler nach Anspruch 5 oder Anspruch 6, bei dem die Grenzfläche zwischen dem nichteinkristallinen Halbleiterlaminatteil Qᵢ und der ersten oder zweiten Elektrode, die die lichtreflektierende Schicht aufweist, über Unregelmäßigkeiten verfügt, die eine diffuse Reflexionsfläche erzeugen.

8. Photovoltaischer Wandler nach einem der Ansprüche 2 bis 7, bei dem das nichteinkristalline Halbleiterlaminatteil Qᵢ ganz oder teilweise aus Si, SiₓC₁₋ₓ (0 < x < 1), SiₓGe₁₋ₓ (0 < x < 1) oder Si₃N₄₋ₓ (0 < x < 4) gebildet ist.

9. Photovoltaischer Wandler nach einem der Ansprüche 2 bis 8, bei dem das nichteinkristalline Halbleiterlaminatteil Qᵢ eine erste nichteinkristalline Halbleiterschicht (8) von erstem Leitungstyp, eine zweite nichteinkristalline Halbleiterschicht (9) vom i-Typ, die auf der ersten nichteinkristallinen Halbleiterschicht ausgebildet ist, und eine dritte nichteinkristalline Halbleiterschicht (10) vom zweiten, dem ersten Leitungstyp entgegengesetzten Leitungstyp aufweist, die auf der zweiten nichteinkristallinen Halbleiterschicht ausgebildet ist, und bei dem der Halbleiterübergang ein pin-Übergang ist.

10. Photovoltaischer Wandler nach Anspruch 9, bei dem das Substrat und die erste Elektrode Eᵢ lichtdurchlässig sind, und bei dem die erste nichteinkristalline Halbleiterschicht (8) die erste Elektrode Eᵢ kontaktiert und eine breitere Energielücke aufweist als die zweite und dritte nichteinkristalline Halbleiterschicht.

11. Photovoltaischer Wandler nach Anspruch 9, bei dem das Substrat und die erste Elektrode Eᵢ lichtdurchlässig sind, und bei dem die erste Elektrode Eᵢ die erste Halbleiterschicht kontaktiert und die erste und die dritte nichteinkristalline Halbleiterschicht eine breitere Energielücke aufweisen als die zweite nichteinkristalline Halbleiterschicht.

12. Photovoltaischer Wandler nach Anspruch 9, bei dem die zweite Elektrode Fᵢ lichtdurchlässig ist, und bei dem die dritte nichteinkristalline Halbleiterschicht (10) die zweite Elektrode Fᵢ kontaktiert und eine breitere Energielücke aufweist als die erste und die zweite nichteinkristalline Halbleiterschicht.

13. Photovoltaischer Wandler nach Anspruch 9, bei dem die zweite Elektrode Fᵢ lichtdurchlässig ist und die dritte Halbleiterschicht kontaktiert, und bei dem erste und die zweite nichteinkristalline Halbleiterschicht eine breitere Energielücke aufweisen als die zweite nichteinkristalline Halbleiterschicht.

14. Photovoltaischer Wandler nach einem der Ansprüche 2 bis 13, bei dem die erste Elektrode Eⱼ und die erste Elektrode Eⱼ₊₁ voneinander durch eine erste Nut Gⱼ getrennt sind, wobei sich die zweite Elektrode Fⱼ₊₁ auf dem nichteinkristallinen Halbleiterlaminatteil Qⱼ der ersten Elektrode Eⱼ gegenüberliegend erstreckt, bei dem eine zweite Nut Oⱼ in das nichteinkristalline Halbleiterlaminatteil Qᵢ so eingeschnitten ist, daß sie sich zwischen der zweiten Elektrode Fⱼ₊₁ und der ersten Elektrode Eⱼ erstreckt, und bei dem sich der Kopplungsabschnitt Kⱼ in die zweite Nut Oⱼ hinein erstreckt.

15. Photovoltaischer Wandler nach Anspruch 14, bei dem sich die zweite Nut Oⱼ in die erste Elektrode Eⱼ hinein erstreckt.

16. Photovoltaischer Wandler nach Anspruch 15, bei dem sich die zweite Nut Oⱼ in die erste Elektrode Eⱼ mit kleinerer Breite hinein erstreckt als in das nichteinkristalline Halbleiterlaminatteil Qⱼ.

17. Photovoltaischer Wandler nach Anspruch 15 oder Anspruch 16, bei dem sich die zweite Nut Oⱼ durch die erste Elektrode Eⱼ hindurch in das Substrat erstreckt, wo sie eine größere Breite als in der ersten Elektrode Eⱼ aufweist.

18. Verfahren zum Herstellen eines photovoltaischen Wandlers, bei dem mehrere voneinander beabstandete erste Elektroden (Eᵢ) auf einem isolierenden Substrat (1) ausgebildet werden; eine nichteinkristalline Halbleiterschicht (42) auf Siliziumbasis mit einem Bereich von erstem Leitungstyp so ausgebildet wird, daß sie über allen voneinander beabstandeten ersten Elektrode (Eᵢ) liegt; in der Halbleiterschicht (42) mindestens ein Halbleiterübergang ausgebildet wird, wobei ein zweiter Bereich mit entgegengesetztem Leitungstyp getrennt vom Bereich mit erstem Leitungstyp vorliegt; die Halbleiterschicht (42) so unterteilt wird, daß mehrere voneinander getrennte Halbleiterschichten (Qᵢ) gebildet werden, die jeweils einer der mehreren ersten Elektroden (Eᵢ) zugeordnet sind, und um einen Abschnitt einer jeweiligen ersten Elektrode freigelegt wird; eine zweite Elektrodenschicht (43) ausgebildet wird, die über den Abschnitten vom zweiten Leitungstyp aller voneinander getrennten Halbleiterschichten (Qᵢ) liegt und die freigelegten Abschnitte der ersten Elektroden (Eᵢ) kontaktiert, und die zweite Elektrodenschicht (43) so unterteilt wird, daß mehrere getrennte zweite Elektroden (Fᵢ) festgelegt werden, die jeweils einer jeweiligen ersten Elektrode (Eᵢ) und einer jeweiligen Schicht der voneinander abgetrennten Halbleiterschichten (Qᵢ) zugeordnet sind, um mit diesen ein photoelektrisches Element (Uᵢ) zu bilden, wobei jedes photoelektrische Element mit benachbarten photoelektrischen Elementen dadurch in Reihe geschaltet wird, daß eine Elektrode (Fⱼ₊₁) jedes Elements (Uⱼ₊₁) mit einem integral ausgebildeten Kopplungsabschnitt (Kⱼ) versehen wird, der in Kontakt mit der anderen Elektrode (Eⱼ) eines anderen Elements steht; **dadurch gekennzeichnet**, daß die erste und die zweite Elektrodenschicht als elektrisch leitende Metalloxidschichten ausgebildet werden, und die die Halbleiterschichtfläche vom p-Typ kontaktierende Metalloxidschicht aus Zinnoxid oder einem im wesentlichen Zinnoxid enthaltenden Metalloxid besteht, und die die Halbleiterschichtfläche vom n-Typ kontaktierende Metalloxidschicht aus Indiumoxid oder einem im wesentlichen Indiumoxid enthaltenden Metalloxid besteht.

19. Verfahren nach Anspruch 18, das folgende Schritte aufweist:
- Ausbilden einer ersten leitenden Metalloxidschicht (41);
- Unterwerfen der ersten leitenden Schicht (41) einem ersten Laserstrahl-Abrastervorgang zum Ausbilden von (n-1) (wobei n eine ganze Zahl größer als 2 ist) sequentiell angeordneten ersten Nuten G₁ bis Gₙ₋₁ und n sequentiell angeordneten ersten Elektroden E₁ bis Eₙ, die jeweils eine leitende Metalloxidschicht aufweisen und jeweils durch die ersten Nuten G₁ bis Gₙ₋₁ voneinander abgetrennt werden;
- Ausbilden der nichteinkristallinen Halbleiterlaminatschicht (42) auf dem Substrat (1), wobei in der Halbleiterschicht (42) mindestens ein Halbleiterübergang so ausgebildet wird, daß er die ersten Nuten G₁ bis Gₙ₋₁ und die ersten Elektroden E₁ bis Eₙ überdeckt, so daß diese Bereiche des nichteinkristallinen Halbleiterlaminatteils auf den Elektroden E₁ bis Eₙ jeweils nichteinkristalline Halbleiterlaminatteile Q₁ bis Qₙ festlegen;
- Unterwerfen der nichteinkristallinen Halbleiterlaminatteile Q₁ bis Qₙ einem zweiten Laserstrahl-Abrastervorgang, um in ihnen (n-1) sequentiell angeordnete zweite Nuten O₁ bis Oₙ₋₁ auszubilden, um durch diese die ersten Elektroden E₁ bis Eₙ₋₁ jeweils zur Außenseite hin freizulegen;
- Ausbilden der zweiten leitenden Schicht (43) so, daß sie sich kontinuierlich über die nichteinkristallinen Halbleiterlaminatteile Q₁ bis Qₙ und in die Nuten O₁ bis Oₙ₋₁ erstreckt, um die Kopplungsbereiche K₁ bis Kₙ₋₁ zu erstellen, die durch die Nuten O₁ bis Oₙ₋₁ mit den ersten Elektroden E₁ bis Eₙ₋₁ verbunden sind; und
- Unterwerfen der zweiten leitenden Schicht (43) einem dritten Laserstrahl-Abrastervorgang zum Ausbilden von Isolierbereichen H₁ bis Hₙ₋₁ auf den jeweiligen nichteinkristallinen Halbleiterlaminatteilen Q₁ bis Qₙ₋₁ in ihr, und zum Ausbilden der zweiten Elektroden als n sequentiell angeordnete Elektroden F₁ bis Fₙ, von denen jede durch einen jeweiligen Isolierabschnitt H₁ bis Hₙ₋₁ abgetrennt ist und jeweils einer ersten Elektrode E₁ bis Eₙ durch die nichteinkristallinen Halbleiterlaminatteile Q₁ bis Qₙ gegenübersteht.

20. Verfahren nach Anspruch 19, bei dem die zweite Nut Oⱼ (j = 1, 2, ..., n-1)) so ausgebildet wird, daß sie sich in die erste Elektrode Eⱼ hinein oder durch diese erstreckt, so daß der Kopplungsbereich Kⱼ mit einer vergrößerten Fläche der ersten Elektrode Eⱼ verbunden werden kann.

21. Verfahren nach Anspruch 19 oder Anspruch 20, bei dem mindestens ein Schritt des ersten, zweiten und dritten Laserstrahl-Abrastervorgangs an Luft ausgeführt wird und ihm eine Behandlung unter Verwendung eines Gases, wie Fluorwasserstoff (HF), Chlorwasserstoff (HCl) oder eines Gases eines fluorierten Kohlenwasserstoffs (CF₄, CFH₃, CClF₂ oder dergleichen), oder unter Verwendung einer Flüssigkeit, wie Flußsäure (HF), Salzsäure (HCl) oder einer Flüssigkeit eines fluorierten Kohlenwasserstoffs (C₂F₃Cl₄, C₂F₃Cl₃ oder dergleichen) folgt.

## Revendications

1. Dispositif de conversion photo-électrique comprenant un substrat isolant (1) et une multiplicité d'éléments photoélectriques adjacents, reliés en série, Uᵢ (i=1, 2, ...n), comprenant chacun une couche semi-conductrice non monocristalline à base de silicium Qᵢ dans laquelle est formée au moins une jonction semi-conductrice et de première et seconde électrodes Eᵢ, Fᵢ entre lesquelles est intercalée ladite couche semi-conductrice Qᵢ de sorte que ladite première électrode Eᵢ établit un contact avec la surface d'une partie de la couche semi-conductrice Qᵢ présentant un premier type de conductivité et que ladite seconde électrode Fᵢ établit un contact avec la surface d'une partie de la couche semi-conductrice Qᵢ présentant un second type de conductivité, ledit second type de conductivité étant d'une conductivité opposée à celle dudit premier type de conductivité, et lesdits éléments photo-électriques Uᵢ étant reliés en série les uns aux autres par le fait qu'une électrode Fⱼ₊₁ (j=1, 2, ...(n-1)) de chaque élément Uⱼ₊₁ comporte une partie de couplage formée solidairement Kⱼ en contact avec l'autre électrode Eⱼ d'un autre élément Uⱼ, caractérisé en ce que lesdites première et seconde électrodes Eᵢ, Fᵢ comprennent des couches d'oxyde métallique électriquement conductrices en contact avec les surfaces respectives de la couche semi-conductrice Qᵢ, et la couche d'oxyde métallique en contact avec la surface de type P de la couche semi-conductrice est de l'oxyde d'étain ou un oxyde métallique se composant principalement d'oxyde d'étain, et la couche d'oxyde métallique en contact avec la surface de type N de la couche semi-conductrice est de l'oxyde d'indium ou un oxyde métallique se composant principalement d'oxyde d'indium.

2. Dispositif de conversion photo-électrique selon la revendication 1, dans lequel:
l'élément semi-conducteur Uᵢ (i=1, 2, ...n) comprend un élément laminé semi-conducteur non monocristallin Qᵢ formé sur la première électrode Eᵢ et dans lequel est formée au moins une jonction semi-conductrice, et la seconde électrode Fᵢ est formée sur l'élément laminé semi-conducteur non monocristallin Qᵢ en regard de la première électrode Eᵢ;
la partie de couplage Kⱼ est réalisée sous la forme d'un prolongement de la seconde électrode Fⱼ₊₁;
la seconde électrode Fᵢ et la partie de couplage Kⱼ se composent d'un oxyde métallique électriquement conducteur sensiblement différent de l'oxyde métallique électriquement conducteur de la première électrode Eⱼ.

3. Dispositif de conversion photo-électrique selon la revendication 2, dans lequel la première électrode Eᵢ et/ou la seconde électrode Fᵢ comprennent une seule couche d'oxyde métallique.

4. Dispositif de conversion photo-électrique selon la revendication 2, dans lequel la première électrode Eᵢ et/ou la seconde électrode Fᵢ comprennent une structure multicouches (4, 5).

5. Dispositif de conversion photo-électrique selon la revendication 4, dans lequel l'une desdites première et seconde électrodes Eᵢ, Fᵢ est conçue pour être transparente vis à vis de la lumière, l'autre desdites première et seconde électrodes Eᵢ, Fᵢ comportant une couche réfléchissant la lumière.

6. Dispositif de conversion photo-électrique selon la revendication 5, dans lequel ladite couche réfléchissant la lumière est une couche métallique.

7. Dispositif de conversion photo-électrique selon la revendication 5 ou la revendication 6, dans lequel l'interface entre l'élément laminé semi-conducteur non monocristallin Qᵢ et celle desdites première et seconde électrodes qui comporte une couche réfléchissant la lumière comprenant des irrégularités définissant une surface de réflexion diffuse.

8. Dispositif de conversion photo-électrique selon l'une quelconque des revendication 2 à 7, dans lequel l'élément laminé semi-conducteur non monocristallin Qᵢ est partiellement ou entièrement composé de Si, SiₓC₁₋ₓ (O<x<1), SiₓGe₁₋ₓ (O<x<1) ou de Si₃N₄₋ₓ (0<x<4).

9. Dispositif de conversion photo-électrique selon l'une quelconque des revendications 2 à 8, dans lequel l'élément laminé semi-conducteur non monocristallin Qᵢ comprend une première couche semi-conductrice non monocristalline (8) d'un premier type de conductivité, une seconde couche semi-conductrice non monocristalline de type I (9) formée sur la première couche semi-conductrice non monocristalline, et une troisième couche semi-conductrice non monocristalline (10) d'un second type de conductivité opposé au premier type de conductivité, formée sur la seconde couche semi-conductrice non monocristalline, la jonction semi-conductrice étant une jonction PIN.

10. Dispositif de conversion photo-électrique selon la revendication 9, dans lequel le substrat et la première électrode Eᵢ sont transparents vis à vis de la lumière, et dans lequel la première couche semi-conductrice non monocristalline (8) est en contact avec la première électrode Eᵢ et présente un intervalle de bande plus large que celui des seconde et troisième couches semi-conductrices non monocristallines.

11. Dispositif de conversion photo-électrique selon la revendication 9, dans lequel le substrat et la première électrode Eᵢ sont transparents vis à vis de la lumière, et dans lequel la première électrode Eᵢ est en contact avec la première couche semi-conductrice, et les première et troisième couches semi-conductrices non monocristallines ont un intervalle de bande plus large que celui de la seconde couche semi-conductrice non monocristalline.

12. Dispositif de conversion photo-électrique selon la revendication 9, dans lequel la seconde électrode Fᵢ est transparente vis à vis de la lumière, et dans lequel la troisième couche semi-conductrice non monocristalline (10) est en contact avec la seconde électrode Fᵢ et présente un intervalle de bande plus large que celui des première et seconde couches semi-conductrices non monocristallines.

13. Dispositif de conversion photo-électrique selon la revendication 9, dans lequel la seconde électrode Fᵢ est transparente vis à vis de la lumière et est en contact avec la troisième couche semi-conductrice, et dans lequel les première et troisième couches semi-conductrices non monocristallines ont un intervalle de bande plus large que celui de la seconde couche semi-conductrice non monocristalline.

14. Dispositif de conversion photo-électrique selon l'une quelconque des revendications 2 à 13, dans lequel la première électrode Eⱼ et la première électrode Eⱼ₊₁ sont séparées par une première rainure Gⱼ, la seconde électrode Fⱼ₊₁ s'étend sur l'élément laminé semi-conducteur non monocristallin Qⱼ en regard de la première électrode Eⱼ, une seconde rainure Oⱼ est découpée dans l'élément laminé semi-conducteur non monocristallin Qᵢ de façon à s'étendre entre la seconde électrode Fⱼ₊₁ et la première électrode Eⱼ et la partie de couplage Kⱼ s'étend à l'intérieur de la seconde rainure Oⱼ.

15. Dispositif de conversion photo-électrique selon la revendication 14, dans lequel la seconde rainure Oⱼ s'étend à l'intérieur de la première électrode Eⱼ.

16. Dispositif de conversion photo-électrique selon la revendication 15, dans lequel la seconde rainure Oⱼ s'étend à l'intérieur de la première électrode Eⱼ sur une plus faible largeur que celle suivant laquelle elle s'étend à l'intérieur de l'élément laminé semi-conducteur non monocristallin Qⱼ.

17. Dispositif de conversion photo-électrique selon la revendication 15 ou la revendication 16, dans lequel la seconde rainure Oⱼ s'étend à travers la première électrode Eⱼ et à l'intérieur du substrat dans lequel sa largeur est supérieure à sa largeur à travers la première électrode Eⱼ.

18. Procédé de fabrication d'un dispositif de conversion photo-électrique consistant à former une multiplicité de premières électrodes espacées (Eᵢ) sur un substrat isolant (1), à former une couche semi-conductrice non monocristalline à base de silicium (42) comprenant une partie de premier type de conductivité en superposition sur toutes les premières électrodes espacées (Eᵢ), ladite couche semi-conductrice (42) comportant, formée dans elle-même, au moins une jonction semi-conductrice et comportant une seconde partie, de type de conductivité opposée, à distance de ladite partie de premier type de conductivité, à diviser ladite couche semi-conductrice (42) de façon à définir une multiplicité de couches semi-conductrices séparées (Qᵢ) associées chacune à une électrode respective parmi ladite multiplicité de premières électrodes (Eᵢ) et de façon à exposer une partie de chacune desdites premières électrodes respectives, à former une seconde couche d'électrode (43) superposée auxdites parties de second type de conductivité de toutes les couches semi-conductrices séparées (Qᵢ) et en contact avec les parties exposées des premières électrodes (Eᵢ), et à diviser la seconde couche d'électrode (43) de façon à définir une multiplicité de secondes électrodes séparées (Fᵢ) associées chacune à une première électrode respective (Eᵢ) et à une couche respective parmi les couches semi-conductrices séparées (Qᵢ) de façon à constituer avec celles-ci un élément photo-électrique (Uᵢ), chaque élément photo-électrique étant relié en série avec des éléments photo-électriques semblables adjacents en dotant une électrode (Fⱼ₊₁) de chaque élément (Uⱼ₊₁) d'une partie de couplage formée de façon solidaire Kⱼ en contact avec l'autre électrode Eⱼ d'un autre élément, caractérisé en ce que les première et seconde couches d'électrodes sont réalisées sous la forme de couches d'oxyde métallique électriquement conductrices, la couche d'oxyde métallique en contact avec la surface de type P de la couche semi-conductrice étant en oxyde d'étain ou en un oxyde métallique composé principalement d'oxyde d'étain, et la couche d'oxyde métallique en contact avec la surface de type N de la couche semi-conductrice étant en oxyde d'indium ou en un oxyde métallique composé principalement d'oxyde d'indium.

19. Procédé selon la revendication 18, ledit procédé comprenant les étapes consistant:
à former sur le substrat (1) une première couche d'oxyde métallique conductrice (41);
à soumettre la première couche conductrice (41) à un premier balayage au faisceau laser pour y former (n-1) (où n est un nombre entier supérieur à 2) premières rainures disposées séquentiellement G₁ à Gₙ₋₁ et n premières électrodes disposées séquentiellement E₁ à Eₙ, comprenant chacune une couche d'oxyde métallique conductrice, séparées par les premières rainures G₁ à Gₙ₋₁, respectivement;
à former la couche laminée semi-conductrice non monocristalline (42) sur le substrat (1), la couche semi-conductrice (42) comportant, formée dans elle-même, au moins une jonction semi-conductrice pour couvrir les premières rainures G₁ à Gₙ₋₁ et les premières électrode E₁ à Eₙ de façon à ce que les régions de l'élément laminé semi-conducteur non monocristallin se trouvant sur les électrodes E₁ à Eₙ définissent les éléments laminés semi-conducteurs non monocristallins Q₁ à Qₙ, respectivement;
à soumettre les éléments laminés semi-conducteurs non monocristallins Q₁ à Qₙ à un second balayage au faisceau laser pour y former (n-1) secondes rainures disposées séquentiellement O₁ à Oₙ₋₁ pour exposer à travers elles les premières électrodes E₁ à Eₙ₋₁ à l'extérieur, respectivement;
à former la seconde couche conductrice (43) de façon à ce qu'elle s'étende en continu sur les éléments laminés semi-conducteurs non monocristallins Q₁ à Qₙ et à l'intérieur des rainures O₁ à Oₙ₋₁ pour fournir des parties de couplage K₁ à Kₙ₋₁ qui sont reliées aux premières électrodes E₁ à Eₙ₋₁ par l'intermédiaire des rainures O₁ à Oₙ₋₁; et
à soumettre la seconde couche conductrice (43) à un troisième balayage au faisceau laser pour y former des parties isolantes H₁ à Hₙ₋₁ sur les éléments laminés semi-conducteurs non monocristallins Q₁ à Qₙ₋₁, respectivement, et pour réaliser les secondes électrodes sous la forme de n électrodes disposées séquentiellement F₁ à Fₙ, chacune étant isolée par les parties isolantes H₁ à Hₙ₋₁, respectivement, et en regard des premières électrodes E₁ à Eₙ par l'intermédiaire des éléments laminés semi-conducteurs non monocristallins Q₁ à Qₙ, respectivement.

20. Procédé selon la revendication 19, dans lequel la seconde rainure Oⱼ (j=1, 2, ... (n-1)) est formée de façon à s'étendre à l'intérieur ou à travers la première électrode Eⱼ de sorte que la partie de couplage Kⱼ puisse être reliée avec une plus grande zone de la première électrode Eⱼ.

21. Procédé selon la revendication 19 ou la revendication 20, dans lequel au moins l'une des première, seconde et troisième étapes de balayage au faisceau laser est effectuée dans l'air et est suivie d'un traitement utilisant un gaz, tel que du fluorure d'hydrogène (HF), du chlorure d'hydrogène (HCl) ou un gaz fluorocarboné (CF₄, CFH₃, CClF₂, ou analogue) ou un liquide, tel que de l'acide fluorhydrique (HF), l'acide chlorhydrique (HCl) ou un liquide fluorocarboné (C₂F₃Cl₄, C₂F₃Cl₃ ou analogue).
